(19) Europäisches Patentamt
European Patent Office
Office européen des brevets

(11) **EP 4 644 932 A1**

(12) **EUROPEAN PATENT APPLICATION**
published in accordance with Art. 153(4) EPC

(43) Date of publication:
05.11.2025 Bulletin 2025/45

(21) Application number: 23911331.9

(22) Date of filing: 13.10.2023

(51) International Patent Classification (IPC):
G01R 31/392 (2019.01)     B60L 3/00 (2019.01)
B60L 15/20 (2006.01)     B60L 50/60 (2019.01)
B60L 58/12 (2019.01)     B60L 58/16 (2019.01)
F02D 45/00 (2006.01)     G01M 17/007 (2006.01)
G01R 31/367 (2019.01)     G01R 31/382 (2019.01)
G01R 31/385 (2019.01)     G01R 31/389 (2019.01)
H01M 10/42 (2006.01)     H01M 10/48 (2006.01)

(52) Cooperative Patent Classification (CPC):
B60L 3/00; B60L 15/20; B60L 50/60; B60L 58/12;
B60L 58/16; F02D 45/00; G01M 17/007;
G01R 31/367; G01R 31/382; G01R 31/385;
G01R 31/389; G01R 31/392; H01M 10/42;
H01M 10/48

(86) International application number:
PCT/JP2023/037166

(87) International publication number:
WO 2024/142547 (04.07.2024 Gazette 2024/27)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 27.12.2022  JP 2022210801
04.04.2023  JP 2023060878
24.05.2023  JP 2023085761

(71) Applicant: HORIBA, Ltd.
Minami-ku
Kyoto-shi
Kyoto 601-8510 (JP)

(72) Inventors:
• SHIOTA Aoi
  Kyoto-shi, Kyoto 601-8510 (JP)
• KAWAZOE Hiroshi
  Kyoto-shi, Kyoto 601-8510 (JP)
• SAITO Takashi
  Kyoto-shi, Kyoto 601-8510 (JP)
• TANAKA Sayaka
  Kyoto-shi, Kyoto 601-8510 (JP)
• NISHIKAWA Masahiro
  Kyoto-shi, Kyoto 601-8510 (JP)

(74) Representative: Müller Hoffmann & Partner
Patentanwälte mbB
St.-Martin-Strasse 64
81541 München (DE)

(54) **VEHICLE DIAGNOSIS DEVICE, VEHICLE DIAGNOSIS METHOD, AND VEHICLE DIAGNOSIS PROGRAM**

(57) A vehicle diagnosis device includes a characteristic data acquisition portion that acquires a plurality of sets of characteristic data included in a predetermined output pattern of a vehicle, an actual data acquisition portion that acquires output data based on the actual driving of the vehicle in a predetermined period in the past and actual measurement data obtained during driving of the vehicle in the predetermined period as representing actual measurements as to a parameter required in vehicle diagnosis, an equivalent pattern generator that cuts out points or sections that are similar to a plurality of sets of characteristic data from the output data in the predetermined period to generate an equivalent output pattern that is regarded as equivalent to the predetermined output pattern, and an actual measurement extraction portion that extracts, from the actual measurement data in the predetermined period, the actual measurements at each point or in each section in the equivalent output pattern.

EP 4 644 932 A1

FIG.10

INITIAL STAGE (BEFORE BATTERY
DETERIORATION)

AT TEST (AFTER BATTERY
DETERIORATION)

$$\frac{dSOC}{dw} = \frac{\Delta SOC(Initial)}{W2}$$

$$\frac{dSOC}{dw} = \frac{\sum\limits_{k=1}^{n} \Delta SOC_k}{\sum\limits_{k=1}^{n} W_{sk}}$$

SOC1 100%
$\Delta SOC(Initial)$
SOC2

W2          $W_{int}$

SOC1 100%
$\sum\limits_{k=1}^{n} \Delta SOC_k$
SOC2

$\sum\limits_{k=1}^{n} W_{sk}$          $W_{age}$

$$\text{DETERIORATION RATE} = \frac{W_{age}}{W_{int}} \, [\%]$$

$$\text{NUMBER OF CYCLES} \begin{cases} \text{INITIAL STAGE} : 100/\Delta SOC(Initial) \\ \text{AFTER DETERIORATION} : 100/\sum\limits_{k=1}^{n} \Delta SOC_k \end{cases}$$

## Description

### Technical Field

The present invention relates to a vehicle diagnosis device, a vehicle diagnosis method, and a vehicle diagnosis program.

### Background Art

There has been marked development in vehicles provided with an electric motor driven by electric power stored in a secondary battery (e.g., lithium-ion battery; hereinafter referred to simply as "battery"). Under this background, various devices have been devised for estimating the degree of deterioration of the battery. For example, Patent Document 1 discloses a device for estimating the lifetime of a secondary battery based on the condition of the battery as represented by the current value and the voltage value of the battery and the total mileage of the vehicle.

### Citation List

### Patent Literature

Patent Document 1: Unexamined Japanese Patent Application Publication No. 2007-195312

### Summary of Invention

### Technical Problem

These days, studies are conducted on methods for estimating the degree of deterioration of a battery by driving a vehicle on a measurement instrument such as a chassis dynamometer in accordance with the Worldwide harmonized Light duty Test Cycle (WLTC). Practically, however, reproducing the driving cycle of the WLTC (actually driving the vehicle on the measurement instrument) for all vehicles to be inspected or tested is difficult in view of the need for equipment, time, and labor. Thus, studies are required on different methods.

The present invention is made to cope with the above inconvenience and an object of the present invention is to provide a vehicle diagnosis device, a vehicle diagnosis method, and a vehicle diagnosis program that can conduct judgment (diagnosis) on the condition of a vehicle in accordance with a diagnosis method involving the vehicle being driven in a predetermined driving pattern, without the vehicle being actually driven in the predetermined driving pattern.

### Solution to Problem

According to one aspect of the present invention, a vehicle diagnosis device that conducts diagnosis on a vehicle includes a characteristic data acquisition portion that acquires a plurality of sets of characteristic data included in a predetermined output pattern of the vehicle, an actual data acquisition portion that acquires output data based on the actual driving of the vehicle in a predetermined period in the past and actual measurement data representing actual measurements as to a parameter required in vehicle diagnosis, an equivalent pattern generator that cuts out points or sections that are similar to a plurality of sets of characteristic data from the output data in the predetermined period to generate an equivalent output pattern that is regarded as equivalent to the predetermined output pattern, and an actual measurement extraction portion that extracts, from the actual measurement data in the predetermined period, the actual measurements at each point or in each section in the equivalent output pattern.

According to another aspect of the present invention, a vehicle diagnosis method includes an equivalent pattern generation step of cutting out, from output data based on the actual driving of a vehicle in a predetermined period in the past, points or sections that are similar to a plurality of sets of characteristic data included in a predetermined output pattern of the vehicle to generate an equivalent output pattern that is regarded as equivalent to the predetermined output pattern, and an actual measurement extraction step of extracting, from actual measurement data obtained during driving of the vehicle in the predetermined period as representing actual measurements as to a parameter required in vehicle diagnosis, the actual measurements at each point or in each section in the equivalent output pattern.

According to another aspect of the present invention, a vehicle diagnosis program makes a computer carry out the vehicle diagnosis method described above.

**Advantageous Effects of Invention**

According to the present invention, it is possible to conduct judgment (diagnosis) on the condition of a vehicle in accordance with a diagnosis method involving the vehicle being driven in a predetermined driving pattern, without the vehicle being actually driven in the predetermined driving pattern.

**Brief Description of Drawings**

[FIG. 1] is a block diagram schematically showing the configuration of a vehicle diagnosis device according to one embodiment of the present invention.

[FIG. 2] is a graph showing the WLTC driving pattern as one example of a predetermined driving pattern of a vehicle.

[FIG. 3] is a graph showing on an enlarged scale the WLTC driving pattern mentioned above.

[FIG. 4] is a block diagram schematically showing the configuration of the vehicle mentioned above.

[FIG. 5] is an illustrative diagram schematically showing a general procedure of vehicle diagnosis by the vehicle diagnosis device mentioned above.

[FIG. 6] is a flow chart illustrating a specific procedure of a vehicle diagnosis method on the vehicle diagnosis device.

[FIG. 7] is a graph showing one example of actual driving data acquired by an actual data acquisition portion in the vehicle diagnosis device and a generated equivalent driving pattern.

[FIG. 8] is an illustrative diagram showing a distribution of speed and acceleration in the WLTC driving pattern.

[FIG. 9] is an illustrative diagram showing the relationship between feature points and actual measurement values in a unit lattice.

[FIG. 10] shows graphs depicting the relationship between consumed power and SOC of a battery before and after battery deterioration.

[FIG. 11] is a graph showing another example of the predetermined driving pattern mentioned above.

[FIG. 12] is an illustrative diagram showing how to calculate an index for evaluating the degree of matching between profile data and data cut out from the actual driving data.

[FIG. 13] is an illustrative diagram showing the relationship between, in the equivalent driving pattern, total energy consumption after correction and SOC after correction.

[FIG. 14] is a block diagram showing another configuration of the controller in the vehicle diagnosis device.

[FIG. 15] is an illustrative diagram schematically showing a circuit that includes the battery mentioned above and a vehicle load.

[FIG. 16] is a graph schematically showing the change, in the equivalent driving pattern, of total resistance before battery deterioration against the lapse of time.

[FIG. 17] is the graph in Fig. 16 on a magnified scale along the vertical axis.

[FIG. 18] is an illustrative diagram showing the circuit in Fig. 15 along with a voltage without a voltage drop across the internal resistance of the battery.

[FIG. 19] is a graph schematically showing the change of an output voltage before battery deterioration against the lapse of time.

[FIG. 20] is a graph showing the discharge characteristics of the battery at different temperatures.

[FIG. 21] is an illustrative diagram showing an equivalent driving pattern along with a change pattern of the altitude information of the vehicle.

[FIG. 22] is an illustrative diagram showing on an enlarged scale a part of the equivalent driving pattern and the change pattern of the altitude information in Fig. 21 in a given period.

[FIG. 23A] is a graph showing time series data of momentary fuel consumption in one cycle in an equivalent driving pattern.

[FIG. 23B] is a graph showing the change of the cumulative value of fuel injection in each section.

[FIG. 24A] is a graph showing time series data of the momentary $CO_2$ emission amount in one cycle in an equivalent driving pattern.

[FIG. 24B] is a graph showing the change of the cumulative value of the $CO_2$ emission amount in each section.

[FIG. 25] is a graph showing a driving pattern as a reference for the vehicle.

[FIG. 26] is an illustrative diagram showing the distribution of feature points in the above-mentioned driving pattern as a predetermined output pattern.

[FIG. 27] is a scatter diagram showing the distribution of all feature points extracted from the actual driving data at predetermined time intervals.

[FIG. 28] is an illustrative diagram showing one example of an equivalent output pattern.

[FIG. 29A] is a graph showing the cumulative values of momentary fuel consumption accompanying the feature points included in the above-mentioned predetermined output pattern.

[FIG. 29B] is a graph showing the cumulative values of momentary fuel consumption accompanying points included in the above-mentioned equivalent output pattern.

[FIG. 30A] is a graph showing the cumulative value of momentary $CO_2$ emission amount accompanying the feature points included in the above-mentioned predetermined output pattern.

[FIG. 30B] is a graph showing the cumulative value of momentary $CO_2$ emission amount accompanying the points included in the equivalent output pattern.

[FIG. 31] is a graph showing the change of altitude during driving of the vehicle.

[FIG. 32] is a graph showing the change of the intake air temperature of the engine.

## Description of Embodiments

Now, an illustrative embodiment of the present invention will be described with reference to the accompanying drawings.

[1. Configuration of Vehicle Diagnosis Device]

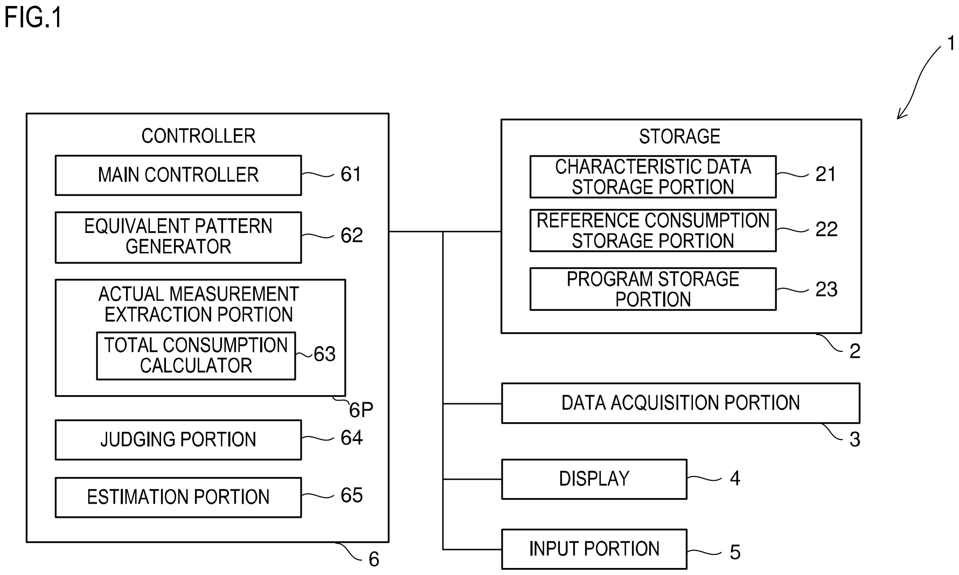

Fig. 1 is a block diagram schematically showing the configuration of a vehicle diagnosis device 1 according to an embodiment. The vehicle diagnosis device 1 is a device that conducts diagnosis on a vehicle based on, for example, the condition of energy consumption on the vehicle. The vehicle diagnosis device 1 can conduct diagnosis on vehicles incorporating an engine (including hybrid vehicles), vehicles incorporating a secondary battery such as a lithium-ion battery (hereinafter, also referred to simply as battery), and vehicles incorporating a fuel cell.

The condition of energy consumption mentioned above refers specifically to the amount or rate of energy consumption. Thus, with vehicles incorporating an engine, it means the amount of fuel such as gasoline or diesel fuel consumed, or fuel economy; with vehicles incorporating a battery, it means power consumption, or the power consumption rate; and, with vehicles incorporating a fuel cell, it means the amount of, for example, hydrogen consumed. Examples of test items in vehicle diagnosis include, with vehicles incorporating an engine or a fuel cell, drop in the fuel economy and deterioration of the drive system and, with vehicles incorporating a battery, deterioration of the drive system and drop in the power consumption rate or the degree (rate) of deterioration of the battery. The following description deals with an example where diagnosis is conducted on a vehicle incorporating a battery.

The vehicle diagnosis device 1 is implemented on an information processing device such as a personal computer. The vehicle diagnosis device 1 includes a storage 2, a data acquisition portion 3, a display 4, an input portion 5, and a controller 6.

The storage 2 is a memory for storing various kinds of data and can be implemented with, for example, a hard disc, an SSD (solid state drive), an optical disc, a magnetic disc, a non-volatile memory, or the like. The storage 2 includes a characteristic data storage portion 21, a reference consumption storage portion 22, and a program storage portion 23.

The characteristic data storage portion 21 stores characteristic data of a plurality of sections included in a predetermined driving pattern of a vehicle. The predetermined driving pattern is a pattern conforming to the WLTC, for example, that is, the WLTC driving pattern. Note that, instead of the WLTC driving pattern, the predetermined driving pattern can be a driving pattern conforming to the UDDS (Urban Dynamometer Driving Schedule) used in North America or the like.

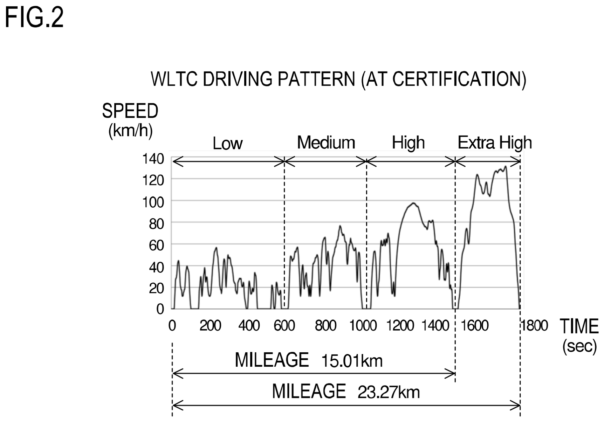

Fig. 2 is a graph showing one example of the WLTC driving pattern of vehicle certification. The WLTC driving pattern is a pattern that shows the change of the speed of the vehicle against the driving time and divides into a plurality of parts identified as low speed, medium speed, high speed, extra high speed, and the like. For the registration of a new model vehicle, it is driven according to the WLTC driving pattern to measure its power consumption rate or fuel economy. This power consumption rate or fuel economy as measured on the brand-new vehicle is registered by predetermined authorities as certificated data. Further, if in the future a regulation is introduced to stipulate the degree of deterioration of the battery after a certain period of driving, the need may arise to measure the degree of deterioration of the battery in some way in a test, in which case one possible way is to measure the power consumption rate in a WLTC run as at the time of registration. In vehicles (battery vehicles, gasoline vehicles, or fuel cell vehicles), as the drive system deteriorates in the course of long-term use, their power consumption rate or fuel economy is considered to drop.

As mentioned above, in a regular test of vehicles, it is practically difficult to reproduce the WLTC driving cycle for all vehicles to be tested. Here, in the embodiment, from driving data in a predetermined period before the test, a pattern equivalent to the WLTC driving pattern at the time of certification (equivalent driving pattern) is generated and, according to the equivalent driving pattern, diagnosis is conducted in conformity with a diagnosis method involving the vehicle being driven in the WLTC driving pattern. The diagnosis method according to the embodiment will be described in detail later.

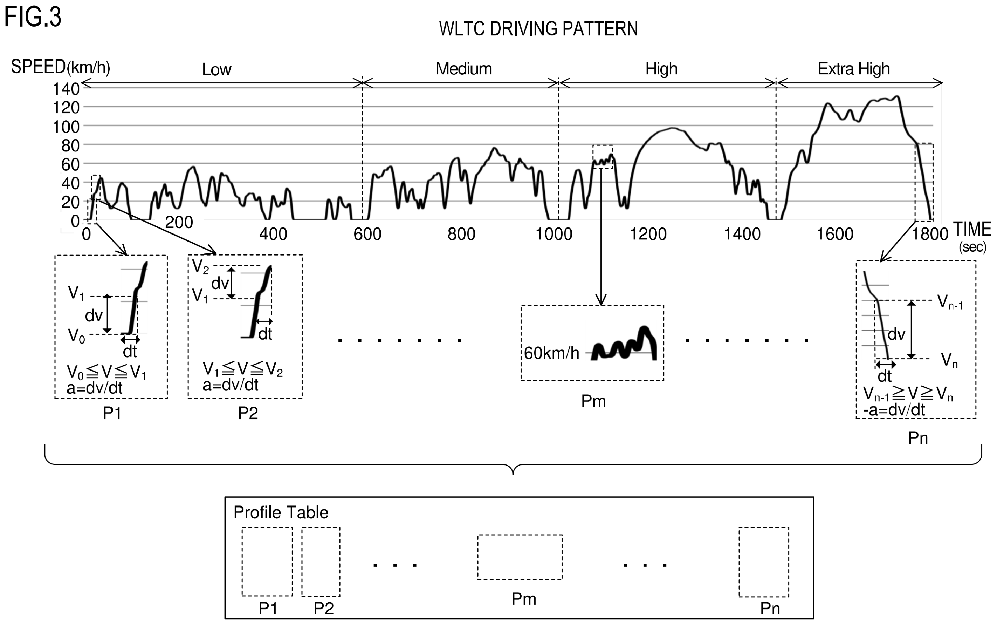

Fig. 3 is a graph showing on an enlarged scale the WLTC driving pattern in Fig. 2. The characteristic data mentioned above is, for example, at least one of the vehicle speed and acceleration in each of the plurality of time sections into which the WLTC driving pattern is divided. In the following description, the characteristic data in each time section is also referred to as a profile. For example, profile P1 comprises vehicle speed V satisfying $V_0 \leq V \leq V_1$ and acceleration a obtained from a = dv/dt. In Fig. 3, m and n are positive integers. In the embodiment, n profiles P1 to Pn included in one cycle of the WLTC driving pattern are previously stored in the characteristic data storage portion 21 as a profile table.

The reference consumption storage portion 22 shown in Fig. 1 stores the amount of energy consumption (e.g., power consumption) of the vehicle per WLTC driving pattern as a reference energy consumption. The program storage portion 23 stores operation programs for operating the controller 6.

The data acquisition portion 3 is an actual data acquisition portion that acquires, from the vehicle, actual driving data in a predetermined period in the past and actual consumption data representing the amount of the driving energy (e.g., electric power) consumed by the vehicle during driving in the predetermined period. Here, the actual driving data mentioned above is data representing the actual condition of the vehicle during driving and includes, for example, at least one of vehicle speed and acceleration. Note that in vehicles incorporating an internal-combustion engine such as an engine, the actual driving data includes, in addition to the vehicle speed or acceleration just mentioned, revolutions, torque, and the like of the engine (details will be given later).

If the characteristic data storage portion 21 previously (initially) stores characteristic data, the characteristic data storage portion 21 alone (without the data acquisition portion 3) can be regarded as a characteristic data acquisition portion. Or, if the characteristic data storage portion 21 previously stores characteristic data, the data acquisition portion 3 can acquire the characteristic data from the characteristic data storage portion 21. In this case, the data acquisition portion 3 can be regarded as a characteristic data acquisition portion. Instead, characteristic data can be acquired from the outside by the data acquisition portion 3 before it is stored in the characteristic data storage portion 21. In this case, the data acquisition portion 3 alone can be regarded as a characteristic data acquisition portion or the data acquisition portion 3 and the characteristic data storage portion 21 together can be regarded as a characteristic data acquisition portion.

Note that the vehicle diagnosis device 1 need not include the characteristic data storage portion 21 and need only acquire characteristic data from the outside (e.g., from an external server) via the data acquisition portion 3. That is, the characteristic data acquired from the outside by the data acquisition portion 3 need not be stored in a memory corresponding to the characteristic data storage portion 21. In this case, too, the data acquisition portion 3 constitutes a characteristic data acquisition portion that acquires characteristics data.

If the reference consumption storage portion 22 previously (initially) stores reference energy consumption data, the reference consumption storage portion 22 alone (without the data acquisition portion 3) can be regarded as a reference consumption acquisition portion. Or, if the reference consumption storage portion 22 previously stores the reference energy consumption data, the data acquisition portion 3 can acquire the reference energy consumption data from the reference consumption storage portion 22. In this case, the data acquisition portion 3 can be regarded as a reference consumption acquisition portion. Instead, the reference energy consumption data can be, after being acquired from the outside by the data acquisition portion 3, stored in the reference consumption storage portion 22. In this case, the data acquisition portion 3 alone can be regarded as a reference consumption acquisition portion or the data acquisition portion 3 and the reference consumption storage portion 22 together can be regarded as a reference consumption acquisition portion.

Note that the vehicle diagnosis device 1 need not include the reference consumption storage portion 22 and need only acquire reference energy consumption data from the outside (e.g., from an external server) via the data acquisition portion 3. That is, the reference energy consumption data acquired from the outside by the data acquisition portion 3 need not be stored in a memory corresponding to the reference consumption storage portion 22. In this case, too, the data acquisition portion 3 constitutes a reference consumption acquisition portion that acquires reference energy consumption data.

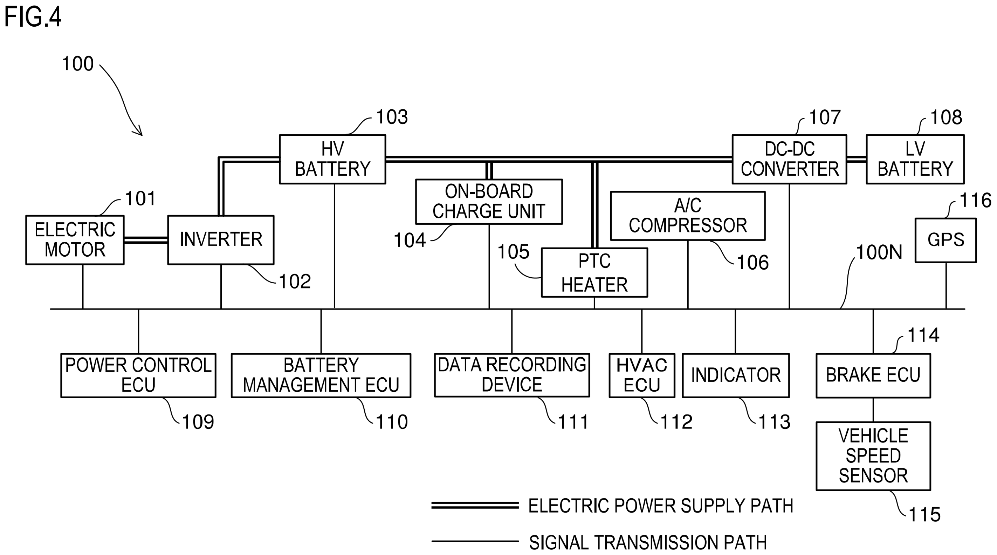

The data acquisition portion 3 is implemented with, for example, a communication portion that allows wired or wireless communication with the vehicle. For example, the communication portion can include a cable and an adopter for communication with the OBD (on board diagnostics) II terminal of an in-vehicle network 100N (see Fig. 4) such as a CAN (controller area network) (for wired communication), or can include a transmission/reception circuit (modulator and demodulator circuits) and an antenna (for wireless communication).

The display 4 is implemented with a display device such as a liquid-crystal display device that displays information. The input portion 5 is implemented with input devices such as a keyboard, a touch pad, a touch panel, and a mouse. Note that the actual consumption data described above can be directly entered via the input portion 5. In this case, the input portion 5 constitutes the data acquisition portion 3.

The controller 6 is implemented with a central arithmetic processing device called a CPU (central processing unit). The controller 6 includes a main controller 61, an equivalent pattern generator 62, a total consumption calculator 63, a judging portion 64, and an estimation portion 65. The main controller 61 controls the operation of different portions of the vehicle diagnosis device 1. The functions of the equivalent pattern generator 62, the total consumption calculator 63, the judging portion 64, and the estimation portion 65 will be discussed in the course of the description of operation given later.

Note that the total consumption calculator 63 is included in an actual measurement extraction portion 6P. The actual measurement extraction portion 6P extracts, from the actual measurement data in the predetermined period described above acquired by the data acquisition portion 3, actual measurements at each point or in each section in the equivalent driving pattern. Here, the actual measurements refer to actual measurements as to parameters required in vehicle diagnosis and include, for example, energy consumption during driving of the vehicle (e.g., power consumption in electric vehicles, the amount of fuel injected in gasoline vehicles), SOC (state of charge; rate of charge) of the battery, the voltage value and the current value of the battery, the amounts of emitted components (such as $CO_2$, CO, and NOx) of the exhaust gas, the amount of dust from the tires or the brakes.

[2. Configuration Example of Vehicle]

Next, an example of the configuration of the vehicle as the target of diagnosis by the vehicle diagnosis device 1 according to the embodiment will be described. Fig. 4 is a block diagram showing an outline of the configuration of a vehicle 100. The vehicle 100 includes an electric motor 101, an inverter 102, an HV (high voltage) battery 103 implemented with, for example, a lithium-ion battery, an on-board charge unit (charger) 104, a PTC (positive temperature coefficient) heater 105, an A/C compressor 106, a DC-DC converter 107, an LV (low voltage) battery 108 (e.g., 12 V battery), a power control ECU 109, a battery management ECU 110, a data recording device 111, an HVAC (heating, ventilation, and air conditioning) ECU 112, an indicator 113, a brake ECU 114, and a vehicle speed sensor 115. Note that "ECU" stands for "electronic control unit." In Fig. 4, the supply paths of electric power from the HV battery 103 are indicated by double lines and transmission paths of different signals are indicated by straight lines.

Actual driving data and actual consumption data of the vehicle 100 are stored in, for example, the data recording device 111 and are transmitted on a wired or wireless basis across the in-vehicle network 100N to the vehicle diagnosis device 1 (see Fig. 1). The actual driving data is obtained based on the sensing result, from the vehicle speed sensor 115, of the vehicle speed against the time course. The actual consumption data is obtained by the battery management ECU 110, which manages the HV battery 103.

Each of the ECUs can include a memory in it. For example, the battery management ECU 110 can store information about the battery power of the HV battery 103 in the internal memory. Instead, the brake ECU 114 can store information about vehicle speed in the internal memory. Or, the indicator 113 can store information about the SOC of the HV battery 103 in the internal memory.

[3. General Procedure of Vehicle Diagnosis]

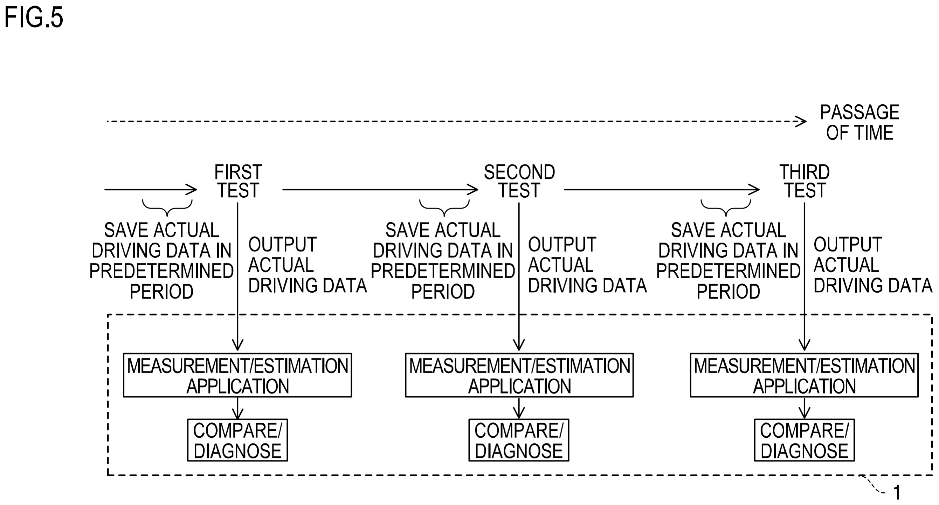

Fig. 5 is an illustrative diagram schematically showing a general procedure of vehicle diagnosis by the vehicle diagnosis device 1. For example, assume that, when a new model vehicle was registered, it was certified in conformity with the WLTC. Then, after the purchase of the vehicle, after a certain period or regularly, the first test, the second test, the third test, and so on (one or more test) are conducted. In these tests, the degree of deterioration of the battery or the like is calculated to conduct vehicle diagnosis. Note that, in the following description, unless otherwise stated, the battery refers to the HV battery 103 in Fig. 4.

Here, in the first test, the vehicle diagnosis device 1 acquires from the vehicle 100 (see Fig. 4) the actual driving data and the actual consumption data in a predetermined period before the first test and, based on those data, calculates (estimates) the battery consumption. Then the vehicle diagnosis device 1 compares the calculated battery consumption with the battery consumption at the time of the WLTC certification so as to make a diagnosis on the degree of deterioration of the battery.

In the second test, the vehicle diagnosis device 1 acquires from the vehicle 100 the actual driving data and the actual consumption data in a predetermined period before the second test and, based on those data, calculates the battery consumption. Then the vehicle diagnosis device 1 compares the calculated battery consumption with the battery consumption at the time of the WLTC certification so as to make a diagnosis on the degree of deterioration of the battery. Note that the vehicle diagnosis device 1 can instead conduct diagnosis on the degree of deterioration of the battery by comparing the calculated battery consumption with the battery consumption calculated in the immediately prior test (here, the first test).

In the third test, the vehicle diagnosis device 1 acquires from the vehicle 100 the actual driving data and the actual consumption data in a predetermined period before the third test and, based on those data, calculates the battery consumption. Then the vehicle diagnosis device 1 compares the calculated battery consumption with the battery consumption at the time of the WLTC certification so as to make a diagnosis on the degree of deterioration of the battery. Note that the vehicle diagnosis device 1 can instead conduct diagnosis on the degree of deterioration of the battery by comparing the calculated battery consumption with the battery consumption calculated in the immediately prior test (here, the second test).

In the fourth and subsequent tests, diagnosis proceeds similarly. In each test, the battery consumption at the time of the WLTC certification can be replaced with the battery consumption during driving of the vehicle in any period before battery deterioration.

[4. Vehicle Diagnosis Method]

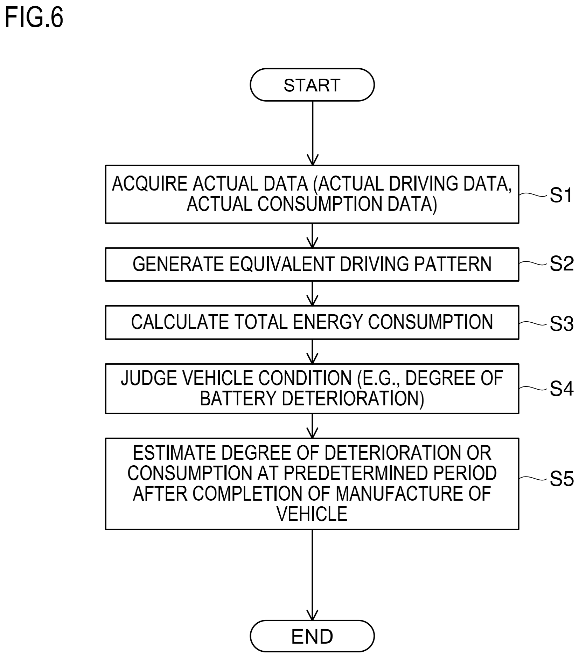

Fig. 6 is a flow chart illustrating a specific procedure of a vehicle diagnosis method on the vehicle diagnosis device 1. Here, assume that the profile table shown in Fig. 3 is stored in the characteristic data storage portion 21 and the power consumption per WLTC driving pattern by the vehicle 100 (see Fig. 4) is stored in the reference consumption storage portion 22 as information about reference energy consumption. While the description below deals with vehicle diagnosis in the first test, the second and subsequent tests proceeds similarly.

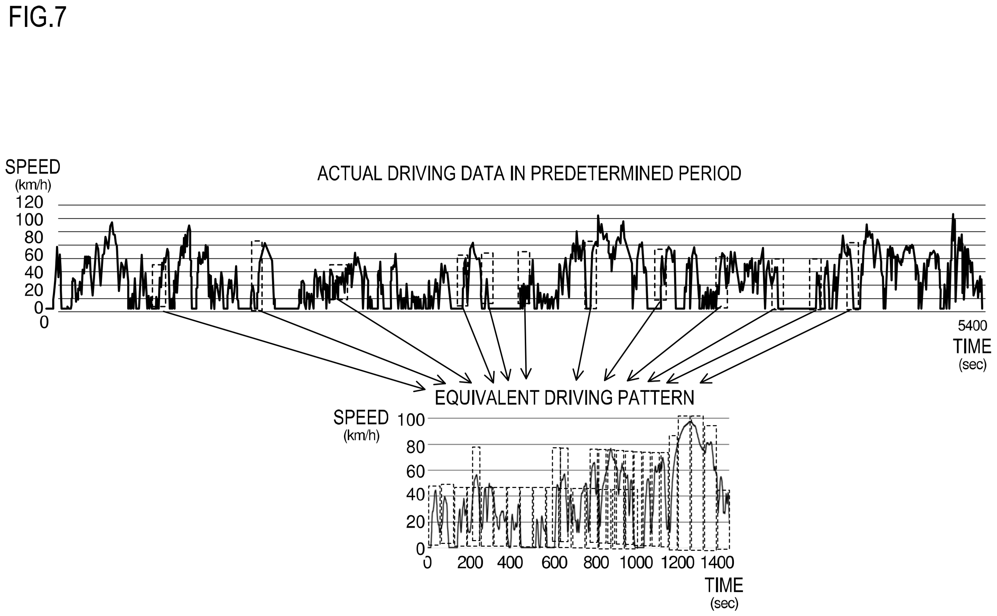

First, the data acquisition portion 3 in the vehicle diagnosis device 1 acquires from the vehicle 100 the actual driving data in a predetermined period in the past and the actual consumption data representing the power consumption as the energy consumption during driving of the vehicle 100 in that predetermined period (S1: actual data acquisition step). Fig. 7 shows one example of the actual driving data acquired by the data acquisition portion 3. Assuming that the vehicle 100 was driven for 90 minutes in a period between one week before the first test and the test, the actual driving data and the actual consumption data for electric power for those 90 minutes are stored, for example, in the data recording device 111 (see Fig. 4) on the vehicle 100. The data acquisition portion 3 acquires, from the data recording device 111 through communication via the network 100N, the actual driving data and the actual consumption data described above.

Next, the equivalent pattern generator 62 cuts out sections that are similar to a plurality of sets of characteristic data (profiles) from the actual driving data in the above predetermined period and connects them together so as to generate an equivalent driving pattern that can be regarded as equivalent to a predetermined driving pattern (here, the WTLC driving pattern) (S2: equivalent pattern generation step). Fig. 7 also shows one example of such an equivalent driving pattern. Fig. 7 shows an example of an equivalent driving pattern generated by cutting out, from the actual driving data, sections that are similar to the characteristic profiles of three parts of the WLTC driving pattern in Fig. 3, namely low speed, medium speed, and high speed, excluding extra high speed.

Here, similarity can be judged based on whether the speed or acceleration in the characteristic data is within a predetermined range of speed or acceleration in the actual driving data. Or, similarly can be judged by pattern matching between the waveform of the characteristic data and the waveform of the actual driving data.

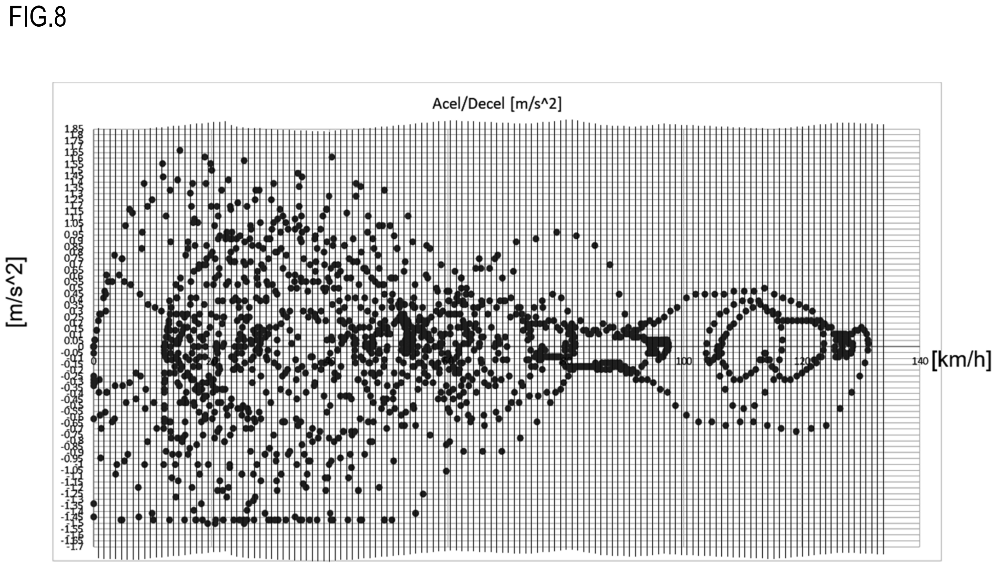

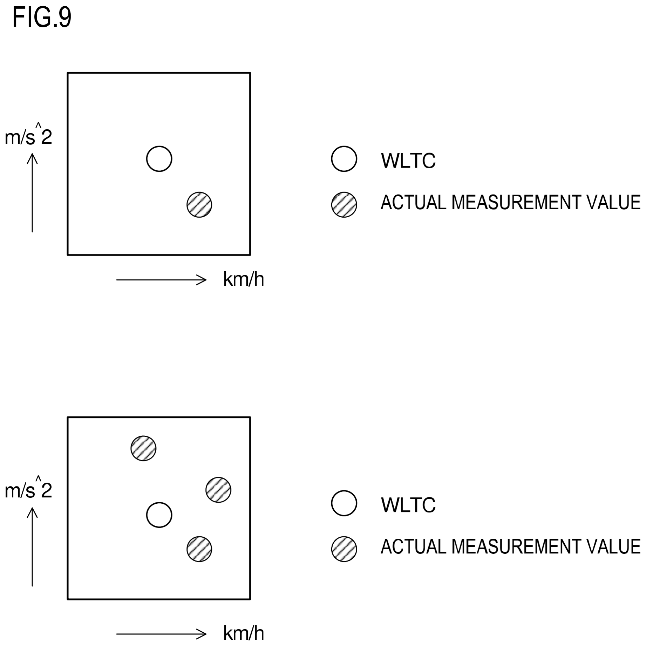

Or, similarity can be judged by making, from the actual driving data, a distribution map (scatter diagram) representing the relationship between speed and acceleration, comparing it with a distribution map (scatter diagram) representing the relationship between speed and acceleration in the characteristic data extracted (sampled) from the WLTC driving pattern shown in Fig. 8, and judging any overlapping point to be similar between them. Or, as shown in Fig. 9, at top, in a two-dimensional coordinate system representing the relationship between speed and acceleration, a unit lattice can be considered that has its center at a feature point (identified by "WLTC" in Fig. 9) representing the speed and acceleration in the characteristic data. The unit lattice can stretch across any range of speed and any range of acceleration, and its size can be set appropriately. If an actual measurement value (point representing the speed and acceleration in the actual driving data) is included in the unit lattice, that actual measurement value can be judged to be a point similar to the characteristic data.

Note that if, as shown in Fig. 9, at bottom, a plurality of actual measurement values are in the unit lattice, the power consumption (or SOC) corresponding to the points of those actual measurement values can be averaged to be associated with the power consumption of the characteristic data.

In any case, the equivalent pattern generator 62 can generate an equivalent driving pattern by cutting out from the actual driving data in the above-mentioned predetermined period a point or section similar to a plurality of sets of characteristic data.

Next, the total consumption calculator 63 calculates, based on the actual consumption data acquired in S1, the total energy consumption by adding up the electric power consumption (consumed power) at each point (the plurality of sampled points) or in each section in the equivalent driving pattern generated in S2 (S3: total consumption calculation step). Specifically, the total consumption calculator 63 calculates the above total energy consumption by extracting and adding up, from the actual consumption data acquired in S1, that is, the actual consumption data (actual measurement data) during driving of the vehicle in the above mentioned predetermined period, the actual measurements (here, power consumption) at each point or in each section in the equivalent driving pattern generated in S2. Thus, the total consumption calculation step in S3 is included in the actual measurement extraction step.

For example, assume that one cycle of the equivalent driving pattern is the same as one cycle (here, from a low speed part to a high speed part) of the WLTC driving pattern. The total energy consumption W in the equivalent driving pattern is given as the sum of the consumed power in as many sections similar to the characteristic data as the number of profiles. That is, if the consumed power in each section is Ws1, Ws2, Ws3, and so on and the number of profiles is n, the total energy consumption W is given by $\Sigma Wsk$ (where k is an integer from 1 to n). Note that if a plurality of points are extracted (sampled) from the equivalent driving pattern, the sum of the consumed power in the sections mentioned above can be replaced with the sum of the consumed power at those points extracted from the equivalent driving pattern (the same applies as follows).

Next, the judging portion 64 judges the condition (e.g., rate of deterioration of the battery) of the vehicle 100 based on the reference energy consumption that is previously acquired by the data acquisition portion 3 and stored in the reference consumption storage portion 22, that is, the power consumption per WLTC driving pattern previously acquired and the total energy consumption calculated in S3 (S4: judging step). A specific judgment method is described below.

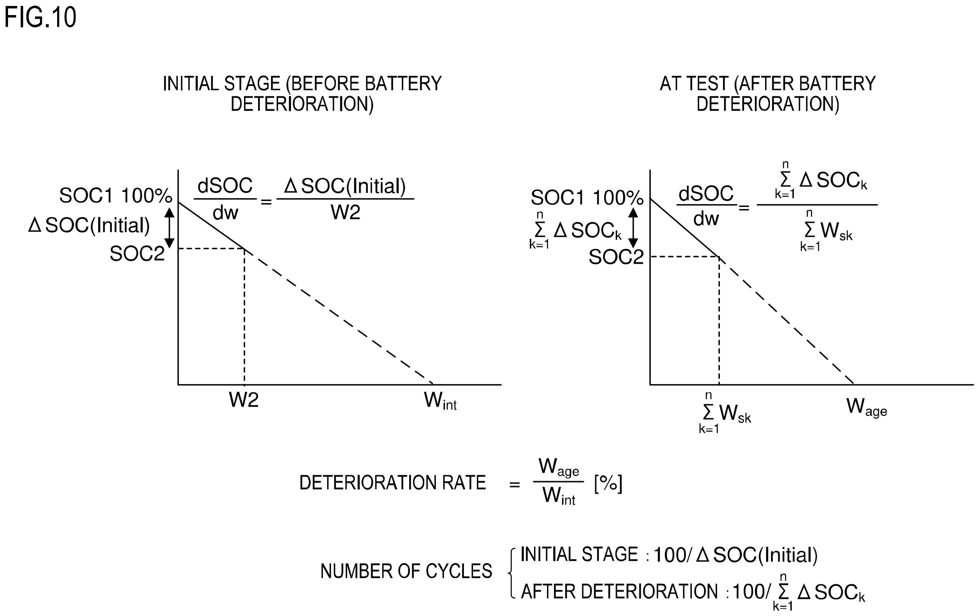

Fig. 10 shows graphs depicting the relationship between the consumed power and the SOC of the battery at the initial stage (before battery deterioration) and at the test (after battery deterioration). Let Wr (%) be the rate of deterioration of the battery, then it is calculated according to Wr = Wage/Wint. Here, Wage represents consumed power of the battery at which the SOC is 0% after battery deterioration and Wint represents the consumed power of the battery at which the SOC is 0% before battery deterioration.

Wint and Wage can be calculated by finding the functions, before and after battery deterioration, expressing the rate of change of the SOC (relationship between the consumed power and the SOC) and finding the values that those functions give at SOC = 0%. Note that, here, for easy understanding, the functions are assumed to be linear functions. The functions can instead be quadratic or higher-order functions and also in that case, the general idea is the same as for the example described below.

Assume that the SOC of the battery at the initial stage, that is, the SOC before battery deterioration, is SOC1 (= 100%), that the SOC after one cycle of the WLTC driving pattern is SOC2, and that the consumed power in one cycle of the WLTC driving pattern is W2. The reference energy consumption mentioned above corresponds to the consumed power W2. When the drop of the SOC after one cycle of the WLTC driving pattern is represented by $\Delta$SOC(Initial), $\Delta$SOC(Initial) = SOC1 - SOC2. When the straight line representing the rate of change of the SOC before battery deterioration is expressed as Y = AX + B, the gradient A of the straight line is A = dSOC/dw = $\Delta$SOC(Initial)/W2. With B = 1 (= 100%), substituting Y = 0 (= 0%) in the above formula gives X = -(1 / A) = Wint.

On the other hand, the total energy consumption W in one cycle of the equivalent driving pattern is $\Sigma$Wsk (where k is an integer from 1 to n) as described above. When the drop of the SOC after one cycle of the equivalent driving pattern is represented by $\Sigma\Delta$SOCk (where k is an integer from 1 to n), $\Sigma\Delta$SOCk = SOC1 - SOC2. When the straight line representing the rate of change of the SOC after battery deterioration is expressed as Y' = A'X' + B', the gradient A' of the straight line is A' = dSOC/dw = $\Sigma\Delta$SOCk/$\Sigma$Wsk. With B' = 1 (= 100%), substituting Y' = 0 (= 0%) in the above formula gives X' = -(1 / A') = Wage.

The judging portion 64 judges, if the rate of deterioration of the battery Wr (= Wage/Wint) is equal to or more than a predetermined value (e.g. 80%), that the battery has no problem and it makes the display 4 (see Fig. 1) indicate accordingly. By contrast, if the rate of deterioration of the battery Wr is less than that predetermined value, the judging portion 64 makes the display 4 indicate that the battery has deteriorated.

Next, the estimation portion 65 estimates, based on the degree of deterioration (the rate of deterioration Wr) of the battery judged by the judging portion 64, the degree of deterioration of the battery or the consumed power (power consumption), per WTLC driving pattern at the lapse of a predetermined period after the completion of the manufacture of the vehicle 100 (SOC1 = 100%) (S5: estimation step). For example, if, in the diagnosis at the first test (e.g., immediately before three years passes after the purchase of the brand-new car), the rate of deterioration of the battery Wr is 98%, the estimation portion 65 estimates, in consideration of the drop (2%) of the rate of deterioration Wr, Wr = 96 % in the diagnosis at the second test (immediately before, for example, two years passes after the first test) and Wr = 94% in the diagnosis at the third test (immediately before, for example, two years passes after the second test).

For consumed power, estimation proceeds similarly. For example, if, in the diagnosis at the first test, the total energy consumption per cycle of the equivalent driving pattern that is regarded as equivalent to one cycle of the WLTC driving pattern is $\Sigma$Wsk, the estimation portion 65 estimates, in the diagnosis at the second test, $\Sigma$Wsk - $\alpha$ (where $\alpha$ is any experimental or empirical value) and, in the diagnosis at the third test, $\Sigma$Wsk - 2$\alpha$.

Such estimation by the estimation portion 65 helps let the user of the vehicle 100 know the end of the lifetime of the battery based on the estimation result.

As described above, the total consumption calculator 63 of the vehicle diagnosis device 1 calculates the total energy consumption $\Sigma$Wsk by generating an equivalent driving pattern that is regarded as equivalent to a predetermined driving pattern (the WLTC driving pattern) from the actual driving data of the vehicle 100 in the past. This allows, without actually driving the vehicle 100 in a predetermined driving pattern, the acquisition of information about the consumption equivalent to the drive energy consumption (power consumption) that can be acquired if the vehicle 100 is driven in that predetermined driving pattern. Thus, the judging portion 64 can judge (conduct diagnosis), without actually driving the vehicle 100 in a predetermined driving pattern, the condition of the vehicle in conformity with a diagnosis method involving the vehicle 100 being driven in that predetermined driving pattern.

In particular, in the embodiment, the data acquisition portion 3 acquires from the vehicle 100, as the actual consumption data, data representing the power consumption of the vehicle 100 during driving in a predetermined period. Then, the total consumption calculator 63 adds up, based on the actual consumption data, the power consumption at each point or in each section in the equivalent driving pattern to calculate the total energy consumption $\Sigma$Wsk. This allows the

judging portion 64 to appropriately judge, based on the reference energy consumption and the total energy consumption, the degree of deterioration of the battery (HV battery 103) storing electric power as the condition of the vehicle 100.

In addition, in the embodiment, the reference energy consumption mentioned above is the amount consumed from the power stored in the battery during driving of the vehicle 100 in a predetermined driving pattern (the WLTC driving pattern). In this case, the judging portion 64 can judge the degree of deterioration of the battery at the test, taking as a reference the consumption of the battery during driving in the predetermined driving pattern.

In S1, the data acquisition portion 3 acquires from the data recording device 111 (see Fig. 4) incorporated in the vehicle 100 the actual driving data and the actual consumption data. In this case, the vehicle diagnosis device 1 can directly access the vehicle 100 to acquire the actual driving data and the like. This allows quick and easy acquisition.

In the embodiment, the predetermined driving pattern mentioned above is the WLTC driving pattern. In this case, the judging portion 64 can judge (conduct diagnosis), without actually driving the vehicle 100 in the WLTC driving pattern, the condition of the vehicle in conformity with a diagnosis method involving the vehicle 100 being driven in the WLTC driving pattern.

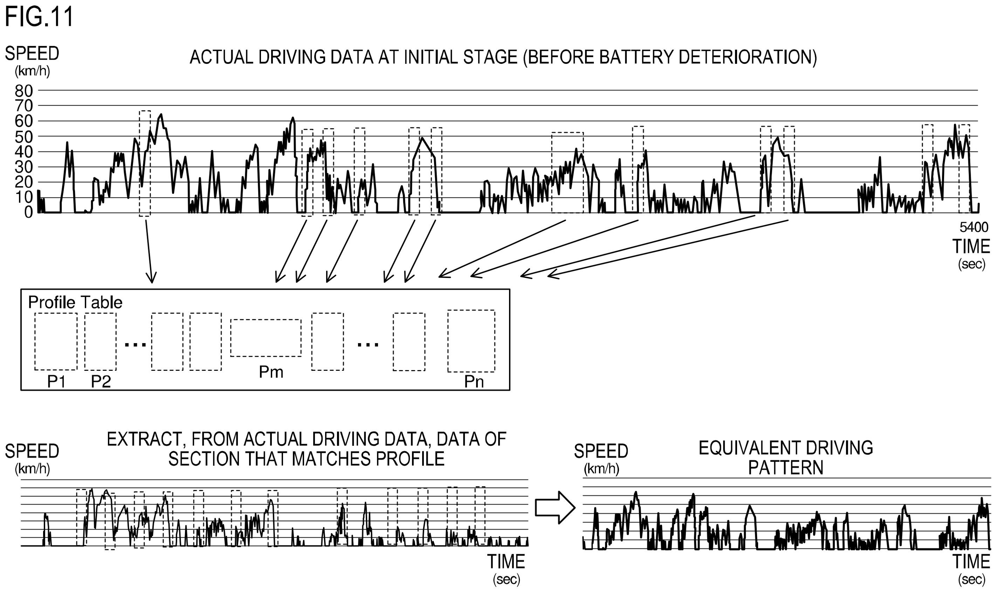

Fig. 11 is a graph showing another example of the predetermined driving pattern. As shown in the figure, as a predetermined driving pattern of the vehicle 100, any driving pattern other than the WLTC driving pattern can be used. For example, the actual driving data acquired before battery deterioration or at any timing can be used as a predetermined driving pattern. Here, the actual driving data acquired before battery deterioration or at any timing can be driving data acquired at the lapse of one month after the WLTC certification, driving data acquired at the lapse of one year after the WLTC certification, or driving data in the equivalent driving pattern generated in the previous test.

A plurality of profiles extracted from the actual driving data before battery deterioration is previously stored as a profile table in the characteristic data storage portion 21. In a test, sections that are similar to those profiles (characteristic data) are cut out from the actual driving data in a predetermined period before the test to generate an equivalent driving pattern. This helps conduct vehicle diagnosis (e.g., diagnosis on the degree of deterioration of the battery) by a method similar to the one in the embodiment.

[5. Judging Matching of Patterns]

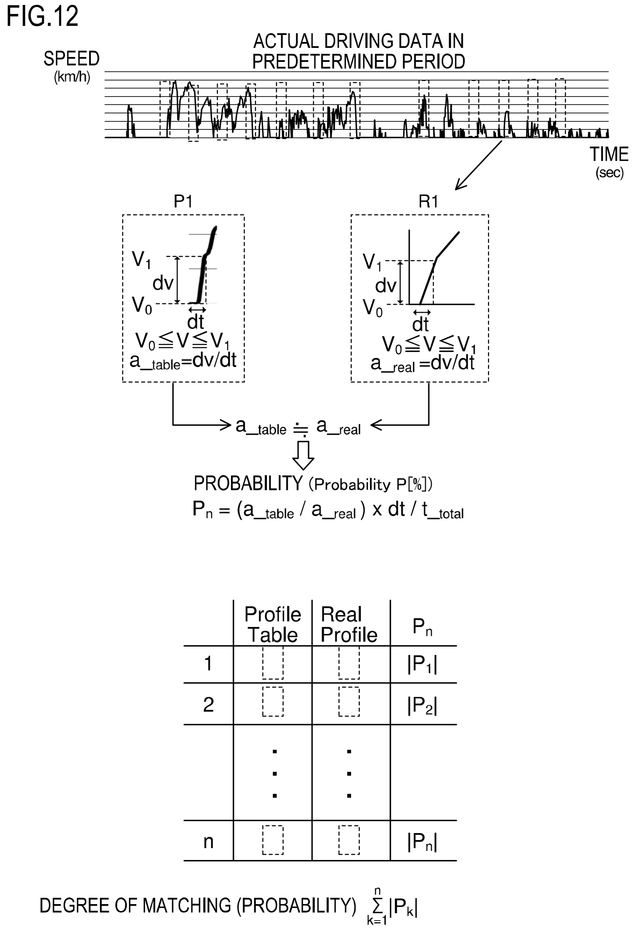

Fig. 12 is an illustrative diagram showing how to calculate an index for evaluating the degree of matching (probability) between the profile data and the data cut out from the actual driving data in S2 described above. In S2, when sections that are similar to the plurality of sets of characteristic data (profiles) are cut out from the actual driving data to generate an equivalent driving pattern, the discrepancy between the profile data and the cut-out data can be calculated as the probability of the ultimate united profile.

For example, let a_table be the acceleration in a given profile, let a_real be the acceleration, in the actual driving data, in the sections that are similar to that profile, and let t_total be the total time in n profiles, then the degree of matching (probability) Pk between the data of the k-th profile and the data of the section that is similar to the k-th profile cut out from the actual driving data can be given by Pk = (a_real/a_table) $\times$ dt/t_total (where k is an integer from 1 to n). Accordingly, the degree of data matching P in all the n sets of profile data is given by $\Sigma$|Pk|.

Accordingly, if the degree of matching P is equal to or more than a predetermined value (e.g., 0.80), it means that the degree of matching between those sets of profile data and the data cut out from the actual driving data is high and it can be understood that the generated equivalent driving pattern has high reliability. On the other hand, if the degree of matching P is less than the predetermined value, it means that the degree of matching between the sets of profile data and the data cut out from the actual driving data is low and it can be understood that the generated equivalent driving pattern has low reliability.

[6. Data Correction Considering Usage Conditions and Environment]

The actual driving load of the vehicle 100 is affected by the usage conditions of the vehicle 100 (the 12 V battery, the air-conditioner, and the like), the environment around it (rain, wind, or road (slopes and corners)), and the like. Thus, it is preferable to calculate and estimate the power consumed due to these factors using the actual driving data and the like to correct the power consumption of comparison data. The correction of power consumption in consideration of the usage conditions and the like will be described below.

For example, the electric power of the LV battery 108 (see Fig. 4) is consumed with the use of electronic devices incorporated in the vehicle 100, such as audio equipment, HVAC blowers, lights, wipers, heating wires, and the like. To the LV battery 108, electric power is supplied from the HV battery 103 shown in Fig. 4 via the DC-DC converter 107 and thus the consumption of the power of the LV battery 108 affects on the consumption of the power of the HV battery 103. The consumed power from the LV battery 108 can be calculated based on the values on the ammeter and on the voltmeter disposed in the supply paths of electric power. For example, let the electric power consumed by a given electronic device be $W_{LV}$ and the voltage value and the current value observed meanwhile be $V_{LV}$ and $I_{LV}$, then $W_{LV} = V_{LV} \times I_{LV}$. Accordingly,

if n electronic devices are provided, the sum of the electric power consumed by the n electronic devices is given by $\Sigma W_{LV}$(N).

Let the minimum consumed power that the electronic devices and the like need with no load at the initial stage, that is, in one cycle of the WLTC driving pattern, be $W_{LV}$(Initial) and the difference of the power consumed by the electronic devices and the like between at the time of the WLTC certification and at the test be $\Delta W_{LV}$, then $\Delta W_{LV} = \Sigma W_{LV}$(N) - $W_{LV}$(Initial).

By contrast, as one effect of the environment around the vehicle 100, that of the driving resistance of the vehicle 100 is considered here. Let the driving resistance of the vehicle 100 be $F_{RL}$, then $F_{RL}$ is given by the formula below:

$$F_{RL} = Crr \times (mg + m_{add}g) + A \times \rho \times Cd \times (v_{veh}^2 + v_{win}^2) + (mg + {}_{madd}g) \times \sin\theta$$

where

Crr represents the rolling resistance coefficient (which can be a value provided by the manufacturer or a value measured at the initial stage (at the time of certification of the model)),
m represents the weight of the vehicle,
g represents the gravity acceleration,
$m_{add}$ represents the weight of passengers plus the load capacity (which can be measured with an on-board sensor (load sensor, vehicle height sensor, or the like),
A represents the frontal projected area of the vehicle,
$\rho$ represents the density of air,
Cd represents the air resistance coefficient,
$v_{veh}$ represents the vehicle speed,
$v_{win}$ represents the wind speed (which can be estimated based on the cloud information), and
$\sin\theta$ represents the slope (which can be calculated with an on-board sensor (G sensor, Gyro sensor, or the like) or can be the slope data in the digital map).

Let the consumed power augmented by the driving resistance of the vehicle 100 be $\Delta W_{RL}$, then $\Delta W_{RL} = F_{RL} \times V_{veh}$.

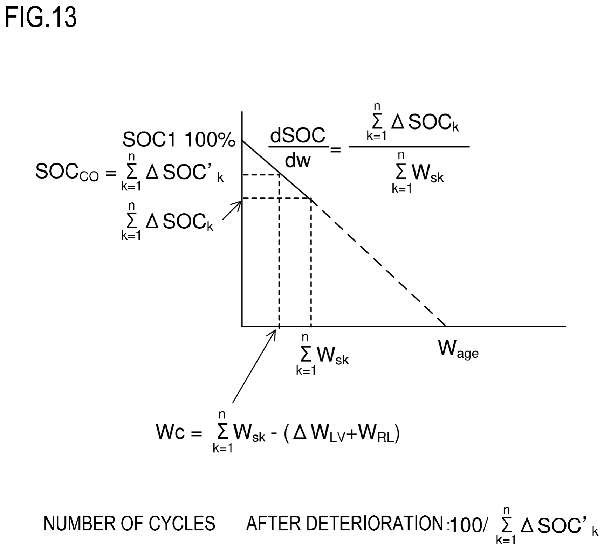

Fig. 13 shows the relationship between, in the equivalent driving pattern, the total energy consumption Wc after correction and $SOC_{CO}$ representing the SOC after correction. The total energy consumption Wc after correction is given by Wc = $\Sigma$Wsk - ($\Delta W_{LV} + \Delta W_{RL}$). In the formula (Y' = A'X' + B') of the straight line indicating the rate of change of the SOC after battery deterioration, when X' = Wc, the value for Y' is $SOC_{CO}$. That is, the SOC (= $SOC_{CO}$) given by subtracting the consumed power corresponding to ($\Delta W_{LV} + \Delta W_{RL}$) from the total energy consumption $\Sigma$Wsk is taken as the SOC in one cycle in the equivalent driving pattern.

As described above, when the data acquisition portion 3 further acquires from the vehicle 100 the data about the usage conditions of and the environment around the vehicle 100, the total consumption calculator 63 excludes the power consumption ($\Delta W_{LV} + \Delta W_{RL}$) from the battery consumed due to the usage conditions of and the environment around the vehicle 100 to calculate the total energy consumption (Wc after correction) of the battery. In this way, the total energy consumption Wc is calculated in consideration of the driving load (the usage conditions and the environment) of the vehicle 100, and thus it can be compared with the no-load condition at the time of the WLTC certification for more appropriate vehicle diagnosis to be conducted.

[7. Other Diagnosis Methods for Vehicle]

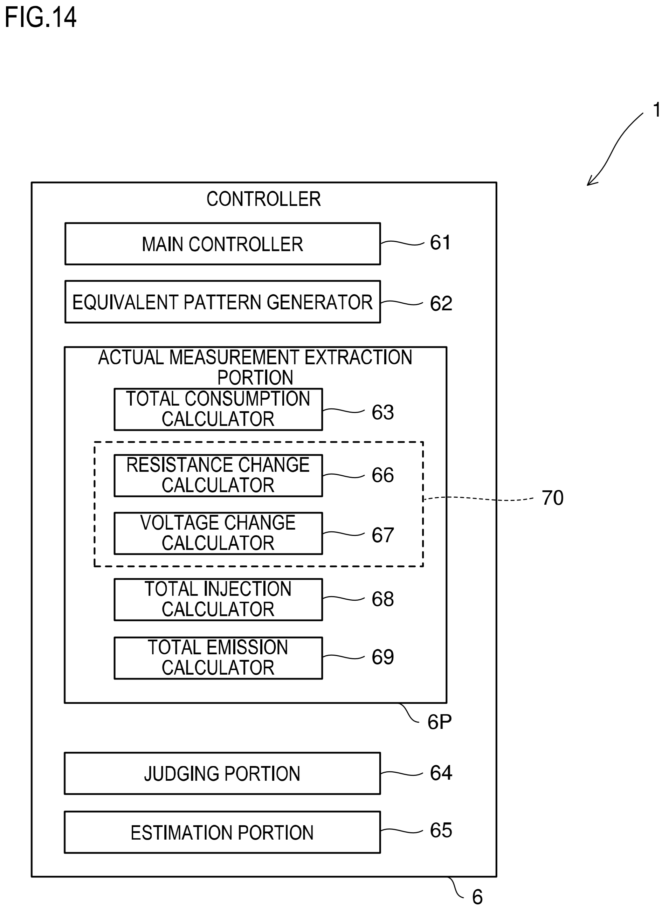

The vehicle diagnosis device 1 according to the embodiment can conduct diagnosis on the condition (e.g., the degree of deterioration of the battery) of the vehicle 100 with parameters other than the power consumption. Fig. 14 is a block diagram showing another configuration of the controller 6 in the vehicle diagnosis device 1. Note that, except for the controller 6, the configuration here is the same as in Fig. 1.

As shown in Fig. 14, the actual measurement extraction portion 6P in the controller 6 includes, in addition to the total consumption calculator 63 described previously, a resistance change calculator 66, a voltage change calculator 67, a total injection calculator 68, and a total emission calculator 69. Note that the actual measurement extraction portion 6P can include at least one of the total consumption calculator 63, the resistance change calculator 66, the voltage change calculator 67, the total injection calculator 68, and the total emission calculator 69. Another diagnosis method for the vehicle 100 will be described below.

(7-1. Vehicle Diagnosis Based on Change of Internal Resistance of Battery)

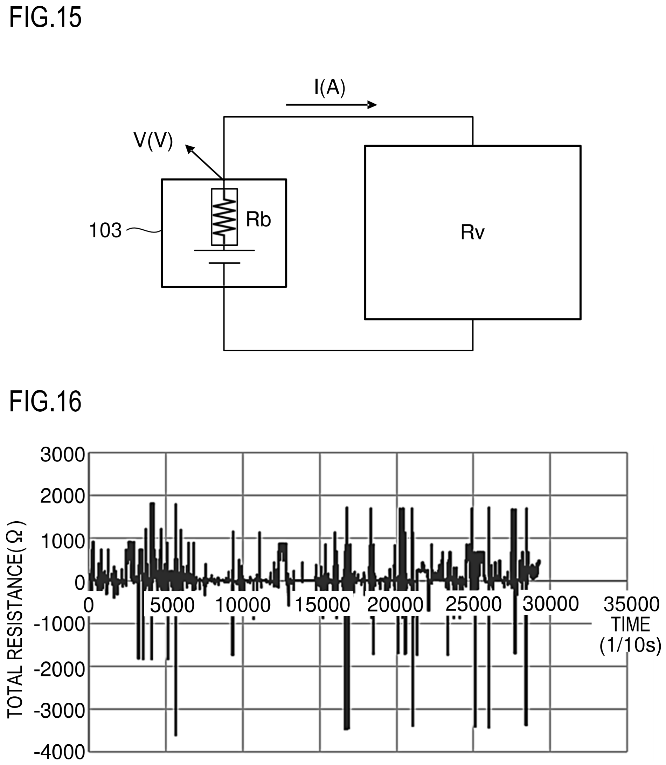

Fig. 15 is an illustrative diagram schematically showing the circuit that includes the HV battery 103 and a vehicle load Rv (Ω). Here, the vehicle load Rv includes the loads (resistances) of electric devices (including a power train including the inverter 102 in Fig. 4, a heat pump, and the like) driven with the electric power supplied from the HV battery 103, electric devices (wipers and the like) driven with the electric power supplied from the LV battery 108, and other electric devices.

Let I (A) and V (V) be the values of the current and voltage, respectively, output from the HV battery 103. In addition, let Rb (Ω) be the internal resistance of the HV battery 103. Then, before deterioration of the HV battery 103 (at the initial stage), for V, I, Rb, and Rv, the following relationship holds:

$$V = I \times (Rv + Rb) \tag{1}$$

Modifying this formula gives:

$$Rv + Rb = V/I \tag{1a}$$

As the HV battery 103 deteriorates over time, the internal resistance of the HV battery 103 increases by ΔRb (Ω) compared with that (reference) before deterioration. Accordingly, after over-time deterioration of the HV battery 103, the following relationship holds:

$$V = I \times (Rv + Rb + \Delta Rb) \tag{2}$$

Modifying this formula gives:

$$Rv + Rb + \Delta Rb = V/I \tag{2a}$$

Note that the left sides of formulae (1a) and (2) are referred to as the total resistance.

I and V above are recorded as actual battery data in, for example, the data recording device 111 (Fig. 4). In addition, the value for Rv is known and the initial value of Rb can be calculated according to formula (1) or (1a). Thus, the resistance change calculator 66 can calculate the change ΔRb of the internal resistance according to formula (2a).

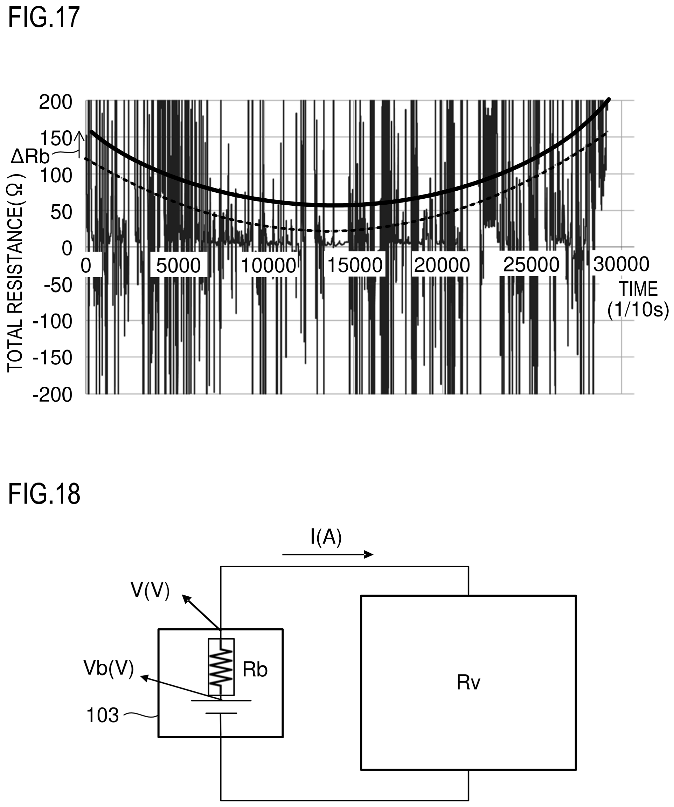

Fig. 16 is a graph showing the equivalent driving pattern before battery deterioration generated with the speed along the vertical axis replaced with the total resistance. That is, the graph in Fig. 16 schematically shows the change with time of the total resistance calculated by extracting, from the actual battery data (voltage value V, current value I) in a predetermined period recorded in the data recording device 111, the voltage value V and the current value I in each section in the equivalent driving pattern and substituting them in formula (1a). Fig. 17 shows the graph in Fig. 16 on a magnified scale along the vertical axis. Note that, Fig. 17 shows an approximation curve (dotted line) of the total resistance before battery deterioration along with an approximation curve (solid line) of the total resistance at the lapse of time. As the HV battery 103 deteriorates, the graph shifts upward (in the direction in which the total resistance increases) by ΔRb. This ΔRb can be calculated, as described above, by the resistance change calculator 66 according to formula (2a). Note that, while Fig. 17 shows in a simplified form the section-by-section transition of the average value of the total resistance in different sections in a form approximated with a quadratic curve, it can instead be approximated with any higher-order curve other than the quadratic curve.

In this way, the calculation of the above change ΔRb by the resistance change calculator 66 allows the judging portion 64 to judge the condition of the vehicle 100 based on the change ΔRb. For example, the judging portion 64 can judge, if ΔRb is equal to or more than a threshold value, that the HV battery 103 has deteriorated and can judge, if ΔRb is less than the threshold value, that the HV battery 103 has not deteriorated.

In this way, in a case where the actual measurement data includes the actual battery data representing as the actual measurements the current value I and the voltage value V of the HV battery 103 during driving of the vehicle 100 in a predetermined period, the resistance change calculator 66 extracts the current value I and the voltage value V of the HV battery 103 in each section in the equivalent driving pattern from the above-mentioned actual battery data in the predetermined period and calculates, based on the extracted current value I and the voltage value V, the change ΔRb of the internal resistance of the HV battery 103 from the reference. This allows the judging portion 64 to judge the degree of deterioration of the HV battery 103 based on the change ΔRb. From the description above, it can be understood that the resistance change calculator 66 constitutes a change calculator 70 that calculates the change ΔRb.

(7-2. Vehicle Diagnosis Based on Change of Battery Voltage)

Fig. 18 is an illustrative diagram showing the circuit in Fig. 15 along with a voltage Vb before the voltage drop across the internal resistance Rb of the HV battery 103. Note that the voltage Vb is assumed to be known and constant. Then, before battery deterioration of the HV battery 103 (at the initial stage), for V, Vb, I, Rb, and Rv, the following relationship holds:

$$V = I \times (Rv + Rb) \tag{1}$$

$$V = Vb - Rb \times I \tag{3}$$

As the internal resistance of the HV battery 103 increases by ΔRb due to over-time deterioration of the HV battery 103, the value V of the voltage output from the HV battery 103 decreases. Here, the voltage value V of the HV battery 103 after over-time deterioration is given by the following formula:

$$V = Vb - (Rb + \Delta Rb) \times I \tag{4}$$

That is, assuming that ΔRb × I = ΔV, as the HV battery 103 deteriorates over time, the voltage value V decreases by ΔV compared with before deterioration.

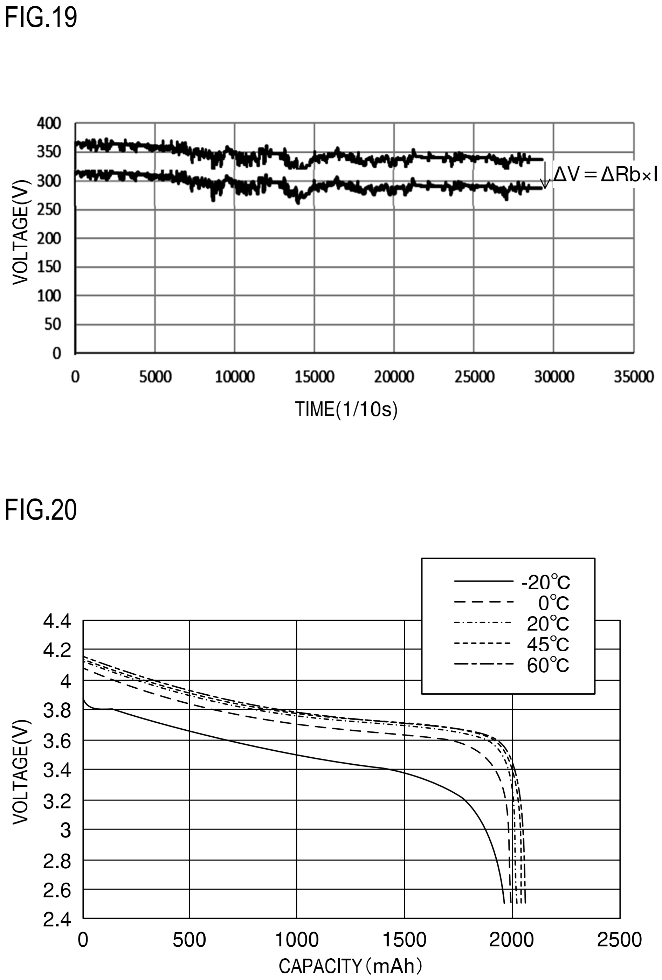

Fig. 19 is a graph showing the equivalent driving pattern before battery deterioration generated with the speed along the vertical axis replaced with the voltage value V of the HV battery 103. That is, the graph in Fig. 19 schematically shows the change with time of the voltage value V calculated by extracting, from the actual battery data (voltage value V) in a predetermined period recorded in the data recording device 111, the voltage value V in each section in the equivalent driving pattern and substituting it in formula (3). As the HV battery 103 deteriorates, the graph shifts downward (in the direction in which the voltage value V decreases) by ΔV.

Accordingly, in a case where the actual measurement data includes the actual battery data representing as the actual measurements the voltage value V of the HV battery 103 during driving of the vehicle 100 in a predetermined period, the voltage change calculator 67 can, by extracting the voltage value V in each section in the equivalent driving pattern from the above-mentioned actual battery data in the predetermined period, calculate the change ΔV from the reference (e.g., the value before deterioration) of the extracted voltage value V. This allows the judging portion 64 to judge the condition of the vehicle 100 based on the change ΔV. For example, the judging portion 64 can judge, if ΔV is equal to or more than a threshold value, that the HV battery 103 has deteriorated and can judge, if ΔV is less than the threshold value, that the HV battery 103 has not deteriorated. Note that ΔV can be a momentary value (instantaneous value) of the voltage or an average value of the voltage in each section. From the description above, it can be understood that the voltage change calculator 67 constitutes the change calculator 70 that calculates the change ΔV.

Note that, for a constant work rate W, W = V × I, dictates that, as the voltage value V decreases, the current value I increases. Thus, if as the HV battery 103 deteriorates over time the voltage value V decreases by ΔV compared with before deterioration, the current value I increases by ΔI. Accordingly, in a case where the actual measurement data includes the actual battery data representing as the actual measurements the current value I of the HV battery 103 during driving of the vehicle 100 in a predetermined period, the change calculator 70 can, by extracting the current value I in each section in the equivalent driving pattern from the above-mentioned actual battery data in the predetermined period, calculate the change ΔI from the reference (e.g., the value before deterioration) of the extracted current value I. This allows the judging portion 64 to judge the condition of the vehicle 100 based on the change ΔI. For example, the judging portion 64 can judge, if ΔI is equal to or more than a threshold value, that the HV battery 103 has deteriorated and can judge, if ΔI is less than the threshold value, that the HV battery 103 has not deteriorated. Note that ΔI can be a momentary value (instantaneous value) of the current or an average value of the current in each section.

(7-3. Judgment on Deterioration of Battery Considering Temperature)

Fig. 20 is a graph showing one example of the discharge characteristics of the HV battery 103 at different temperatures. As shown in Fig. 20, the HV battery 103 has the characteristics of discharging (the voltage value steeply approaching zero) for a predetermined duration (about 5 hours in the example in Fig. 20). In addition, the discharge characteristics of the HV battery 103 vary depending on temperature: the lower the temperature, the lower the output voltage tends to be. Thus, if the above-described judgment on battery deterioration is made at a low temperature of, for example, -20°C, due to the low output voltage, the HV battery 103 may be falsely judged to have deteriorated despite its not having deteriorated.

To cope with this, preferably, when the temperature of the HV battery 103 lies in a predetermined temperature range (e.g., 0°C or more, and more preferably 20°C or more), the judging portion 64 judges the condition (e.g., degree of deterioration of the battery) of the vehicle 100. This helps reduce the likelihood of a false judgment as mentioned above due to the low temperature of the HV battery 103.

Note that the temperature of the HV battery 103 can be sensed with a sensor incorporated or externally fitted to the HV battery 103, or the temperature of the cooling water for cooling the HV battery 103 can be used instead. In addition, those temperature values can be recorded as temperature data in the data recording device 111 (see Fig. 4).

On the other hand, if the temperature of the HV battery 103 falls out of the predetermined temperature range (e.g., 0°C or more), from the perspective of reducing false judgments as mentioned above, the judging portion 64 can suspend the judgment on the condition (e.g., degree of deterioration of the battery) of the vehicle 100, or it can handle the situation as follows.

Specifically, if the temperature of the HV battery 103 falls out of a predetermined temperature range, the judging portion 64 can judge the condition of the vehicle 100 with the voltage value V of the HV battery 103 corrected to the voltage value V' at a predetermined temperature (e.g., 20°C). For example, if the HV battery 103 has a temperature of -20°C, the judging portion 64 can multiply the detected voltage value V of the HV battery 103 by a previously calculated correction coefficient K to correct it to the voltage value V' at the predetermined temperature (e.g., 20°C); the judging portion 64 can then, with the corrected voltage value V', judge battery deterioration as described above. With the voltage value V corrected in this way, even with the temperature of the HV battery 103 out of a predetermined temperature range, the degree of deterioration of the battery can be judged with a reduced risk of false judgment.

[8. Another Method for Calculating Vehicle Slope]

The slope $\theta$ of the vehicle 100 considered when the driving resistance of the vehicle 100 was considered under [6. Data Correction Considering Usage Conditions and Environment] above can be calculated without using an on-board sensor (G sensor, Gyro sensor, or the like). Another method for calculating the slope $\theta$ will be described below.

As shown in Fig. 4, a GPS (global positioning system) sensor 116 is incorporated in the vehicle 100. The GPS sensor 116 allows acquisition of altitude information of the vehicle 100. The above-mentioned altitude information of the vehicle 100 is recorded in the data recording device 111.

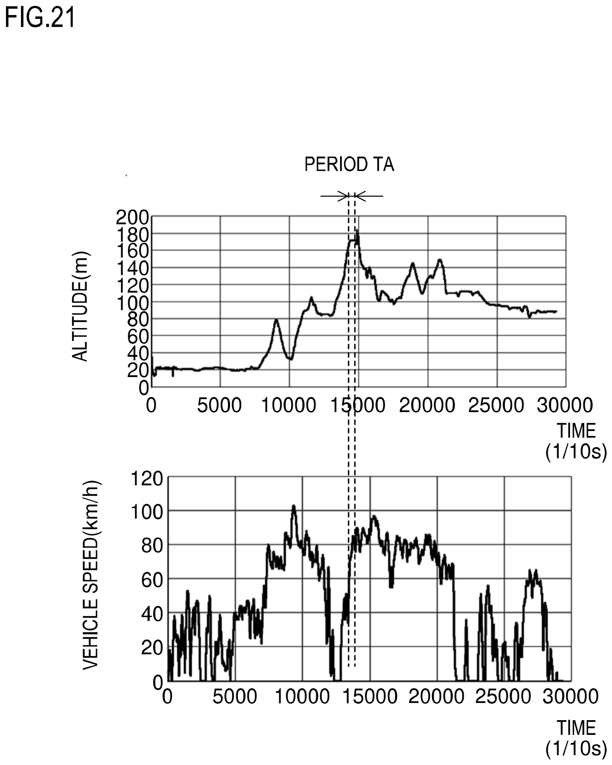

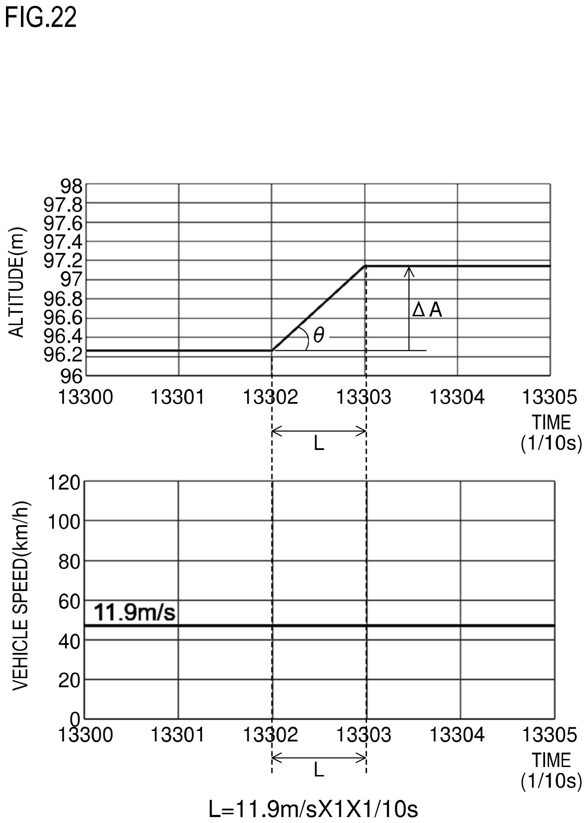

Fig. 21 shows one example of an equivalent driving pattern (at bottom) along with a change pattern of the altitude information of the vehicle 100 extracted from each section in the above-mentioned equivalent driving pattern (at top). Fig. 22 shows on an enlarged scale a part of the equivalent driving pattern and the change pattern of the altitude information in Fig. 21 in a given period TA. In the period TA, assuming that the speed of the vehicle 100 (which can be an average vehicle speed) is constant (e.g., 11.9 m/s), the travel distance L of the vehicle 100 can be given by: vehicle speed $\times$ sampling period = (11.9 m/s) $\times$ (1 $\times$ 1/10 s). According to the relationship among $\theta$, L, and $\Delta$A in the graph in Fig. 22 at top, the slope $\theta$ can be given by the following formula:

$$\theta \; [\text{rad.}] = \arctan (\Delta A/L)$$

In this way, the total consumption calculator 63 shown in Fig. 1 and Fig. 14 can, in calculating the total energy consumption (Wc after correction) of the battery, calculate the slope $\theta$ as one parameter required in calculating the driving resistance $F_{RL}$ of the vehicle 100 according to the above formula. This eliminates the need for the on-board sensor such as a G sensor or a Gyro sensor for directly sensing the slope $\theta$.

[9. Other Examples of Actual Measurement Data]

While the description above deals with, as an example of the actual measurement data acquired by the data acquisition portion 3 (see Fig. 1), the actual consumption data and the actual battery data, this is not meant as any limitation to such data. For example, the actual measurement data can include actual injection data representing the actual measurements of fuel injection during driving of the vehicle 100 in a predetermined period.

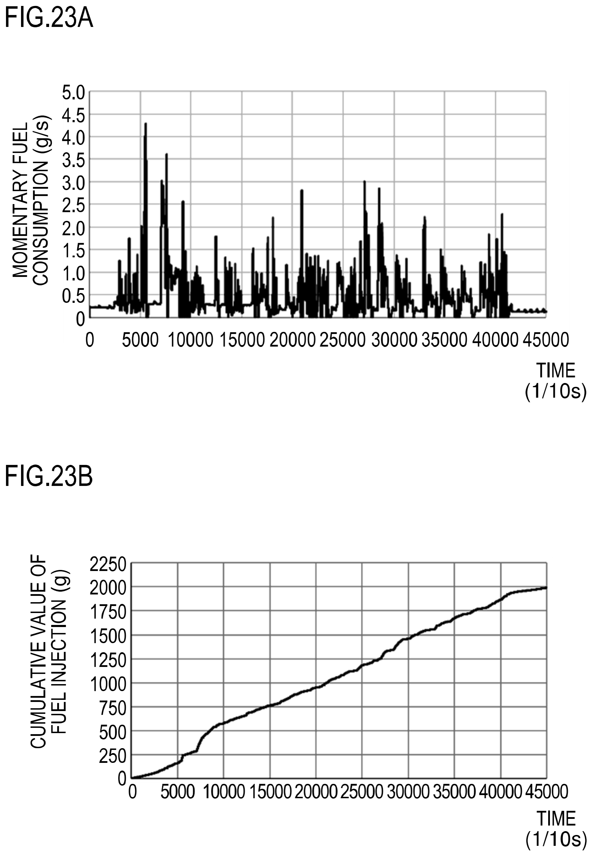

Fig. 23A is a graph showing, assuming that the vehicle 100 is a vehicle driven with fuel such as gasoline or diesel fuel, time series data of the momentary fuel consumption (momentary fuel injection) in one cycle in an equivalent driving pattern. Here, the momentary fuel consumption is a momentary value (in g/s) of fuel injection included in the above-mentioned actual injection data obtained accompanying (at the same time as) speed data at each feature point in the equivalent driving pattern. Fig. 23B is a graph showing the change of the cumulative value of the above-mentioned momentary fuel injection (i.e., the total injection) at each feature point. The total injection just mentioned is calculated by the total injection calculator 68 shown in Fig. 14 adding up the fuel injection at each feature point in the equivalent driving pattern based on the actual injection data described above.

In this way, the calculation of the total injection by the total injection calculator 68 allows the judging portion 64 to conduct diagnosis on the vehicle 100 based on the total injection described above. For example, the judging portion 64 can judge, if the total injection in one cycle in an equivalent driving pattern is equal to or more than a threshold value, that the engine has deteriorated and can judge, if the total injection is less than the threshold value, that the engine has not deteriorated.

Or, the actual measurement data described above can include actual emission data representing as the actual measurements the emission amount of a predetermined component in the exhaust gas during driving of the vehicle 100 in a predetermined period. Note that the predetermined component just mentioned can be $CO_2$, CO, or NOx. In addition, the above-mentioned emission amount can be acquired by sensing the predetermined component in the exhaust gas with an analysis instrument provided as standard equipment in the vehicle 100 and doing arithmetic operations. Or, the above-mentioned emission amount can be acquired by introducing the exhaust gas into an on-board gas analysis instrument mounted on the vehicle 100 afterward.

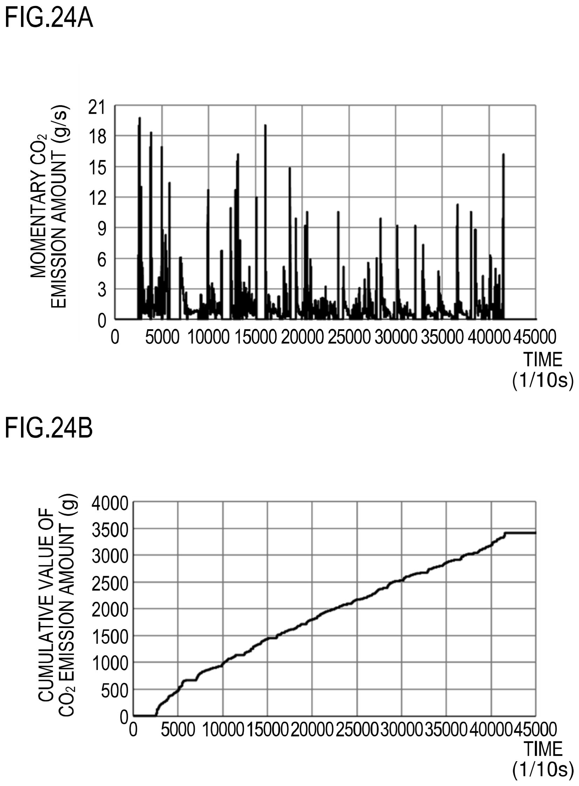

Fig. 24A is a graph showing, assuming that the vehicle 100 is a vehicle driven with fuel such as gasoline or diesel fuel, time series data of the momentary $CO_2$ emission amount in one cycle in an equivalent driving pattern. The above-mentioned emission amount is a momentary value (in g/s) of the $CO_2$ emission amount included in the above-mentioned actual emission data obtained accompanying speed data at each feature point in the equivalent driving pattern. Fig. 24B is a graph showing the change of the cumulative value of each of the above-mentioned momentary emission amount of $CO_2$ (total emission amount) at each feature point. The total emission amount just mentioned can be calculated by the total emission calculator 69 shown in Fig. 14 adding up the $CO_2$ emission amount at each feature point in the equivalent driving pattern based on the actual emission data described above.

In this way, the calculation of the total emission amount by the total emission calculator 69 allows the judging portion 64 to conduct diagnosis on the vehicle 100 based on the total emission amount described above. For example, the judging portion 64 can judge, if the above-described total emission amount in one cycle in the equivalent driving pattern is equal to or more than a threshold value, that the engine has deteriorated and can judge, if the above-described total emission amount is less than the threshold value, that the engine has not deteriorated.

Instead, for example, a measurement instrument for measuring the tread depth of the tires of the vehicle 100 and a measurement instrument for measuring rubber dust from the tires can be used together so that measurement data obtained with them can be used as the actual measurement data described in the embodiment. In this case, the total value of the wear of the tires in one cycle in an equivalent driving pattern can be calculated to judge the condition of the vehicle 100 (degree of deterioration of the tires (need of their replacement)) based on the calculated total value.

Similarly, for example, a measurement instrument for measuring metal dust from brake pads can be used together so that measurement data of metal dust can be used as the actual measurement data described in the embodiment. In this case, the total value of the actual wear of the brake pads in one cycle in an equivalent driving pattern can be calculated to judge the condition of the vehicle 100 (degree of deterioration of brake pads (need of their replacement)) based on the calculated total value.

As described above, the actual measurement data described above can include actual wear data representing as the actual measurements the wear of tires or brake pads during driving of the vehicle 100 in a predetermined period and thus it can be understood that the judging portion 64 can judge the condition of the vehicle 100 based on the total value of the above-described actual wear in each section in an equivalent driving pattern. In addition, instead of accompanying data at each feature point, data extracted from each section in a driving pattern can be used to judge the deterioration of the engine.

The predetermined driving pattern (e.g., the WLTC driving pattern) described above is one example of a predetermined output pattern. That is, the output pattern just mentioned can be the above-described driving pattern representing the change of speed against the lapse of time during driving of the vehicle 100. In this case, an equivalent driving pattern that is regarded as equivalent to a predetermined driving pattern can be understood as one example of the equivalent output pattern.

[10. Method for Judging Degree of Deterioration in Vehicle with Internal Combustion Engine]

As described above, the vehicle 100 can be any vehicle other than a vehicle incorporating a battery and thus can be a vehicle incorporating an internal combustion engine (ICE) such as an engine. In this case, too, the fuel consumption (fuel economy) of the vehicle 100 can be calculated so that, when vehicle diagnosis is conducted, it can be conducted applying to it the method described above.

In the configuration where the vehicle 100 includes the engine, vehicle diagnosis (judgment of the degree of deterioration of the engine) can be conducted also in a manner described below. Note that deterioration of the engine denotes at least one of, as what occurs as the engine is used, a drop in the combustion efficiency below a reference and a rise in the emission amount of a predetermined component contained in the exhaust gas above a reference. A method for judging the degree of deterioration of the engine will be described below. Note that the procedure of a judgment method described below is the same as that shown in the above-described flow chart in Fig. 6. In addition, the judgment method described below can be applied to the judgment not only of the degree of deterioration of the engine incorporated in gasoline vehicles, diesel vehicles, and hybrid vehicles but also of the degree of deterioration of hydrogen internal combustion engines (H2ICE).

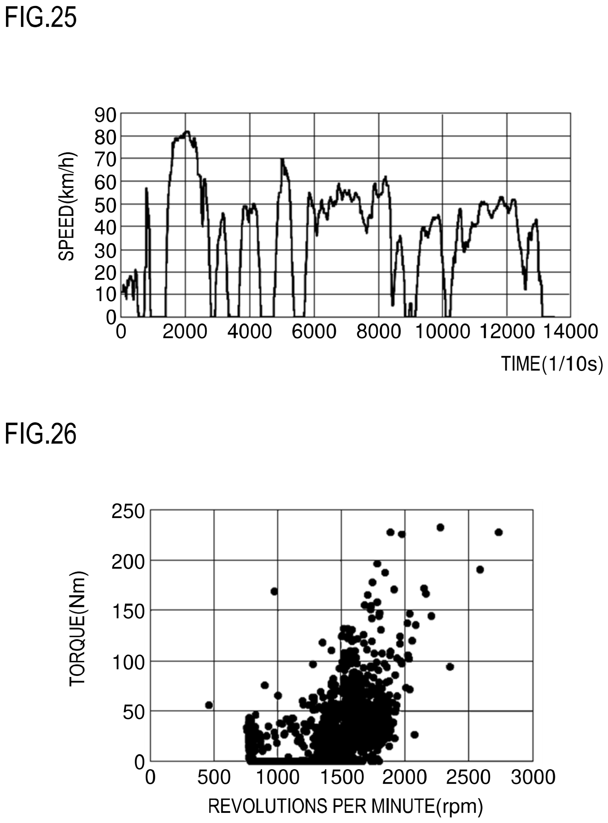

First, preconditions will be described. Fig. 25 shows a driving pattern of the vehicle 100 acquired before engine deterioration. Note that the driving pattern before engine deterioration can be the WLTC driving pattern. Assume that the characteristic data storage portion 21 (see Fig. 1) stores data at each point (each feature point) obtained by sampling the above-mentioned driving pattern at predetermined time intervals (e.g., 100 ms).

Fig. 26 is a scatter diagram showing the distribution of the data of feature points. In the scatter diagram, each feature point is plotted with the revolutions per minute (rpm) of the engine along the horizontal axis and the running torque (Nm) of the engine along the vertical axis. Here, the distribution of feature points representing the pattern shown in the scatter diagram, that is, the relationship between the rpm and torque of the engine during driving in the driving pattern before engine deterioration is defined as "predetermined output pattern." Note that the rpm and torque of the engine can be values (internal values) acquired with a sensor and the like inside the vehicle 100 or values (measurement values) acquired with another measurement instrument connected to the vehicle 100.

In addition, here, assume that fuel consumption and its cumulative value corresponding to each feature point in the predetermined output pattern of the vehicle 100 are stored in the reference consumption storage portion 22 (see Fig. 1) as information about the reference energy consumption.

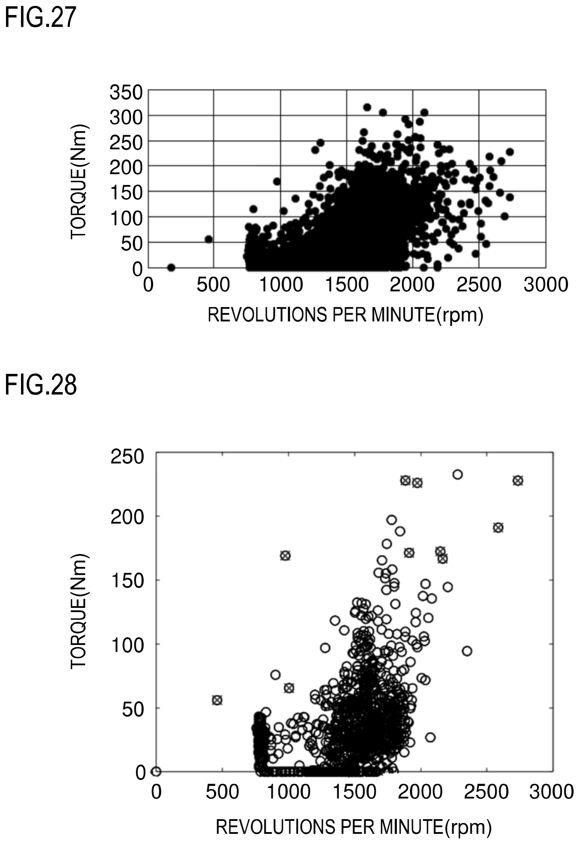

A specific method for judging the degree of deterioration will be described below. The data acquisition portion 3 in the vehicle diagnosis device 1 acquires, from the vehicle 100 or an external device, actual driving data of the vehicle 100 in a predetermined period in the past and actual consumption data representing fuel consumption, that is, energy consumption of the vehicle 100 during driving in the predetermined period (corresponding to S1 in Fig. 6). Note that the predetermined period in the past is assumed to start at a time point after the lapse of predetermined days and hours (after the passage of time or years) from a given time point before engine deterioration of the vehicle 100. Note that the data acquisition portion 3 can directly acquire data (data representing the relationship between the rpm and torque of the engine) in Fig. 27, which will be described later, instead of acquiring the actual driving data in S1.

Next, the equivalent pattern generator 62 cuts out, from the actual driving data in the predetermined period, points that are similar to a plurality of sets of characteristic data (the feature points described above) to generate an equivalent output pattern that is regarded as equivalent to a predetermined output pattern (corresponding to S2 in Fig. 6). Similarity can be judged in a method similar to the methods described previously based on Figs. 8 and 9. For example, the rpm or torque of the engine in the actual driving data can be judged to be similar to the rpm or torque of the engine included in the predetermined output pattern if they are in a predetermined range (in a tolerable error range).

Fig. 27 is a scatter diagram showing the distribution of all the points (points indicating the rpm and torque) extracted from the actual driving data at predetermined time intervals (e.g., 100 ms). The equivalent pattern generator 62 cuts out points that are similar to the feature points shown in Fig. 26 out of the points shown in Fig. 27 to generate an equivalent output pattern. Fig. 28 shows one example of the equivalent output pattern. The equivalent output pattern is a plot of the points that are similar to the feature points, with the rpm of the engine along the horizontal axis and the running torque of the engine along the vertical axis, and the distribution of the points indicated by circles in the figure corresponds to the equivalent output pattern. Note that, in Fig. 28, points indicated by crosses overlaid on circles represent feature points to which no points in the actual driving data are similar.

Next, the total consumption calculator 63 calculates, based on the actual consumption data acquired in S1, total energy consumption by adding up fuel consumption accompanying the points (a plurality of sampled points) included in the equivalent output pattern generated in S2 (corresponding to S3 in Fig. 6). Note that accompanying data (fuel consumption) can be an internal value acquired inside the vehicle 100 or a measurement value acquired with another measurement instrument connected to the vehicle 100.

Then, the judging portion 64 judges the condition (degree of deterioration of the engine) of the vehicle 100 based on the reference energy consumption that is previously acquired by the data acquisition portion 3 and stored in the reference consumption storage portion 22, that is, the fuel consumption (cumulative value) corresponding to the previously-acquired feature points before engine deterioration, and the total energy consumption calculated in S3 (corresponding to S4 in Fig. 6).

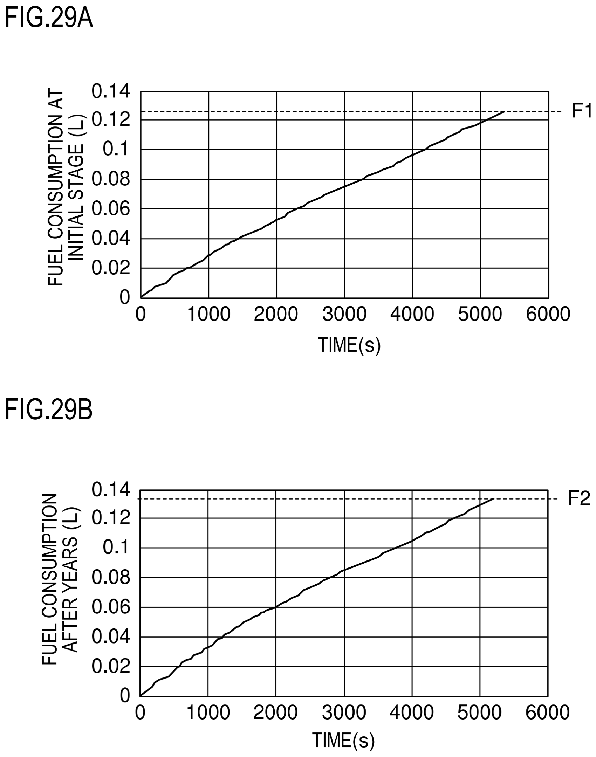

Fig. 29A is a graph showing the cumulative values of momentary fuel consumption (L) accompanying the feature points included in the predetermined output pattern. Fig. 29B is a graph showing the cumulative values of momentary fuel consumption (L) accompanying the points included in the equivalent output pattern. Let the reference energy consumption be $F1$ (L) and the total energy consumption be $F2$ (L), then $F = F2 - F1$ can be understood to give the fuel consumption that occurred extra due to over-time (over-the-year) deterioration of the engine. Thus, the judging portion 64 can judge the degree of deterioration of the engine based on the value of $F$ (extra fuel consumption). For example, it can judge, if $F$ is equal to or more than a predetermined threshold value, that the degree of deterioration of the engine is high and can judge, if $F$ is less than the predetermined threshold value, that the degree of deterioration of the engine is low.

Here, the output of the engine is generally represented as follows:

Engine output (kW) = $2\pi \times$ torque (Nm) $\times$ revolutions per minute (rpm) / 60 / 1000

In a vehicle incorporating an engine, all the driving load including wind and the rolling resistance under friction with the road surface as well as the current consumption by the air-conditioner and the like is reflected in the above-mentioned engine output as a work rate. In addition, the fuel consumption correlates with the engine output. For example, as the engine output increases, the fuel consumption also increases.

Thus, as described above, comparing the data (here, fuel consumption) accompanying the pattern (rpm and torque) of the engine output between at the initial stage (reference before engine deterioration) and after the passage of years (after engine deterioration) helps judge the degree of deterioration of the engine relative to the condition at the initial stage with no correction for the effect of wind and the like (in consideration of wind and the like).

In addition, the predetermined output pattern as reference is a set of points (feature points) indicating the relationship between the rpm and torque of the engine as an internal combustion engine. The equivalent output pattern is a set of points that are regarded as equivalent to the points in the predetermined output pattern. This allows reliable judgment of the degree of deterioration of the engine based on data (here, fuel consumption) accompanying the feature points in a predetermined output pattern and data (here, fuel consumption) accompanying the points in an equivalent output pattern.

The description above deals with an example where the judgment of the degree of deterioration of the engine uses data of fuel consumption as data accompanying the points in the predetermined output pattern and in the equivalent output pattern. Using, instead of fuel consumption, data representing the emission amount of a predetermined component contained in the exhaust gas also allows the judgment of the degree of deterioration of the engine by a method similar to the one described above.

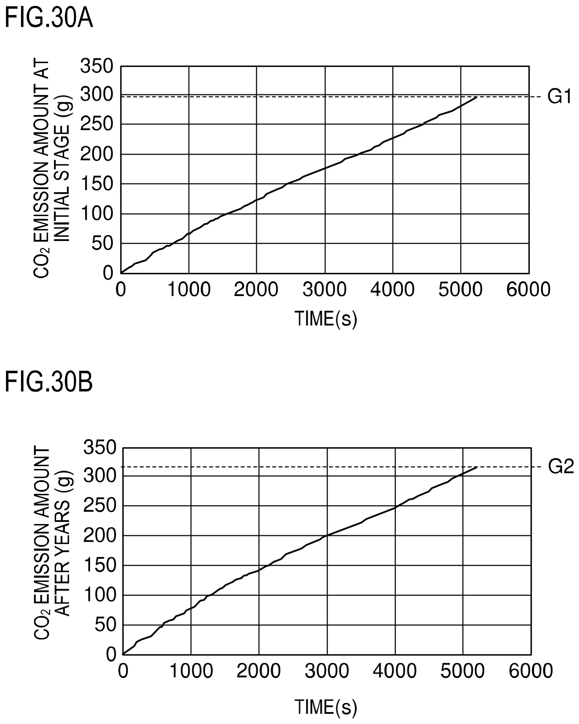

Fig. 30A is a graph showing the cumulative value of momentary $CO_2$ emission amount (g) accompanying the feature points in the predetermined output pattern. Fig. 30B is a graph showing the cumulative value of momentary $CO_2$ emission amount (g) accompanying the points in the equivalent output pattern.

Here, assume that the momentary $CO_2$ emission amount before engine deterioration of the vehicle 100 and its cumulative value are stored in the reference consumption storage portion 22 (see Fig. 1) as information about the reference energy consumption. In addition, let the cumulative value of the momentary $CO_2$ emission amount as the reference energy consumption be G1 (g). Further, assume that in S3 the total consumption calculator 63 calculates the total energy consumption, based on the actual consumption data acquired in S1, by adding up the momentary $CO_2$ emission amount accompanying the points in the equivalent output pattern generated in S2 and let this total energy consumption be G2 (g). In this case, G = G2 - G1 can be understood to be the $CO_2$ emission amount that occurred extra due to the over-time (over-the-year) deterioration of the engine.

Thus, the judging portion 64 can judge the degree of deterioration of the engine according to the value of G (extra $CO_2$ emission amount). For example, it can judge, if G is equal to or more than a predetermined threshold value, that the degree of deterioration of the engine is high and can judge, if G is less than the predetermined threshold value, that the degree of deterioration of the engine is low. That is, the use of the $CO_2$ emission amount as data accompanying the pattern of the engine output (rpm and torque) also allows the judgment of the degree of deterioration of the engine. Note that the emission amount of any component other than $CO_2$ (such as CO, NOx) contained in the exhaust gas is also usable to judge the degree of deterioration of the engine by a method similar to the one described above.

Note that the data (such as fuel consumption or $CO_2$ emission amount) accompanying the points in each scatter diagram can be recorded in a recording medium included in the vehicle or can be recorded outside it (e.g., in a cloud server).

To improve the accuracy of the above-described judgment of the degree of deterioration of the internal combustion engine, factors in a drop in combustion efficiency or a rise in exhaust gas can be taken into consideration in judging the degree of deterioration.

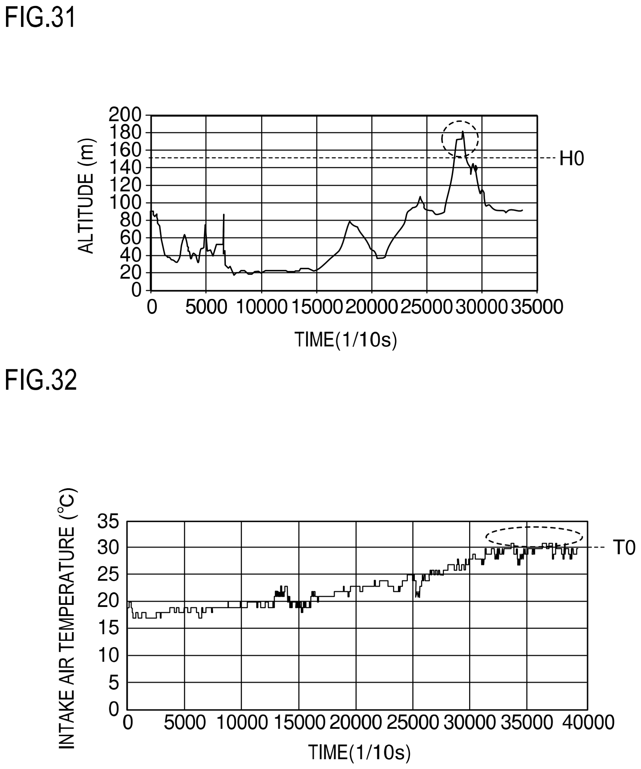

Fig. 31 is a graph showing the change of altitude during driving of the vehicle. When the altitude during driving of the vehicle is high, the combustion efficiency of the engine decreases due to a drop in the atmospheric pressure. Thus, in the scatter diagrams described above, for feature points at altitudes equal to or higher than a predetermined threshold value of H0 and for points that are similar to the feature points, the deterioration of the engine can be judged without using (without considering) data accompanying the points. That is, with the corresponding accompanying data (fuel consumption or emission amount of a predetermined component) excluded, the reference energy consumption and the total energy consumption can be calculated and, based on these reference energy consumption and total energy consumption, the judging portion 64 can judge the degree of deterioration of the engine.

Fig. 32 is a graph showing the change of the intake air temperature of the engine. Note that the intake air temperature corresponds to the outdoor temperature. When the intake air temperature is high, the combustion efficiency of the engine decreases. Thus, in the scatter diagrams described above, for feature points at intake air temperatures equal to or higher than a predetermined threshold value of T0 and for points that are similar to the feature points, the deterioration of the engine can be judged without using data accompanying the points.

As another factor, for example, a rise in rainfall may cause a rise in humidity, leading to a drop in combustion efficiency. Whether humidity is high or low can be judged by sensing raindrops with a raindrop sensor on the vehicle or based on the operation of wipers. Thus if, for example, raindrops keep being sensed or the wipers keep operating for a predetermined time or more, humidity can be estimated to be equal to or higher than a threshold value and the deterioration of the engine can be judged without using the data accompanying the points during that while.

Or, at low temperature, an exhaust catalyst (exhaust gas purification catalyst) exhibits a low effect of eliminating a hazardous component (CO, HC, or NOx) in the exhaust gas, leading to a rise in the emission amount of a predetermined component (e.g., $CO_2$). Thus, in the scatter diagrams described above, for feature points at exhaust catalyst temperatures lower than a predetermined threshold value and for points that are similar to the feature points, the deterioration of the engine can be judged without using data accompanying the points.

Or, rapid acceleration of the vehicle causes a temporary rise in exhaust gas due to an excessive supply of fuel to the engine. This rise in exhaust gas is not proportional to the work rate of the engine. Thus, in rapid acceleration of the vehicle, in the scatter diagrams described above, the deterioration of the engine can be judged without using data accompanying the corresponding feature points and the points that are similar to the feature points.

For any factor other than those mentioned above that affects the combustion efficiency of the engine and the efficiency of exhaust gas elimination, those factors can be taken into consideration in a manner similar as described above to judge the deterioration of the engine. Note that, where the accompanying data is not used, correction can be made based on those factors.

[11. Program]

The controller 6 in the vehicle diagnosis device 1 according to the embodiment can be implemented on a computer with an operation program (application software) installed on it. The computer (e.g., controller 6) reads and executes the program to operate different portions (the main controller 61, the equivalent pattern generator 62, the actual measurement extraction portion 6P (including the total consumption calculator 63), the judging portion 64, and the estimation portion 65) of the controller 6, thereby performing the different processes (steps) described above. This program is acquired by being downloaded externally via, for example, a network and are stored in the program storage portion 23 in the storage 2 or in a memory in the controller 6. The program mentioned above can be in a form of recorded on a computer-readable recording medium such as CD-ROM (compact disk read-only memory) to be read from the recording medium to be stored on the memory mentioned above or the like. That is, the program according to the embodiment is a vehicle diagnosis program for making a computer carry out the vehicle diagnosis method according to the embodiment described above. In addition, the recording medium according to the embodiment is a computer-readable recording medium having the program mentioned above recorded on it.

[12. Supplement]

The actual driving data in a predetermined period shown in Fig. 7, that is, the actual driving data in a predetermined period in the past acquired from the vehicle by the data acquisition portion 3 is one example of output data based on the actual driving of the vehicle in the predetermined period in the past. In addition, the data in the scatter diagram shown in Fig. 27 is also one example of output data based on the actual driving of the vehicle in a predetermined period in the past. That is, output data based on the actual driving of the vehicle in a predetermined period in the past can be engine output (e.g., data representing the relationship between the rpm and torque of the engine).

The vehicle diagnosis device 1 need not include the judging portion 64 or the estimation portion 65. For example, information about the total energy consumption calculated by the total consumption calculator 63 can be transmitted to an external device and judgment and estimation of the degree of deterioration of the battery of the vehicle can be conducted on the external device.

Diagnosis on the degree of deterioration of the battery by the vehicle diagnosis device 1 can be performed at any timing, such as at predetermined intervals, or at the timing of a vehicle inspection or an OBD vehicle inspection. An OBD vehicle inspection refers to a test in which a scan tool (external fault diagnosis device) is connected to a vehicle at the test to read information about the presence/absence of a fault and the operation condition in different devices, thereby checking whether those devices are normally operating.

Around a SOC of 100%, to prevent overcharging of the battery, energy regeneration is usually not performed. Thus, in a region (time zone) without regeneration, the total energy consumption tends to be higher. Accordingly, the total energy consumption is calculated preferably with the region mentioned above taken into consideration. For example, one idea is, in the calculation of the total energy consumption, not to use the data (power consumption) in the region mentioned above.

The power consumed by a heater (e.g., the PTC heater 105 in Fig. 4) at cold starting is higher than when temperature is kept constant. Thus, if the difference between a set temperature and the indoor temperature is large, preferably, the value of the consumed power of a heat pump is not used as data for the calculation of the driving resistance.

A map of the power consumed by equipment (e.g., air conditioner) can be created based on outdoor and indoor temperatures to be recorded as a set reference. The consumed power map can be recorded in the data recording device 111 in the vehicle 100 or in a database at a testing facility.

The energy consumption can be calculated based on the driving voltage and the driving current of a thermal unit (the heat pump or the PTC heater 105) or the A/C compressor 106 in Fig. 4.

While the above description deals with an example where the vehicle diagnosis device 1 is provided outside the vehicle 100, the vehicle diagnosis device 1 can be provided inside the vehicle 100 and be connected to the network 100N so as to be able to communicate with it.

The energy consumption described in the embodiment includes, in addition to power consumption, power consumption rate, fuel consumption (fuel injection), fuel economy, and hydrogen consumption, also the emission amount of a predetermined component (CO, $CO_2$, or NOx) contained in the exhaust gas.

The vehicle diagnosis device described in the embodiment includes a vehicle diagnosis device as described below. That is, a vehicle diagnosis device that conducts diagnosis on a vehicle includes:

a characteristic data acquisition portion that acquires a plurality of sets of characteristic data included in a predetermined driving pattern of the vehicle;

an actual data acquisition portion that acquires actual driving data of the vehicle in a predetermined period in the past and actual measurement data obtained during driving of the vehicle in the predetermined period as representing actual measurements as to a parameter required in vehicle diagnosis;

an equivalent pattern generator that cuts out points or sections that are similar to a plurality of sets of the characteristic data from the actual driving data in the predetermined period to generate an equivalent driving pattern that is regarded as equivalent to the predetermined driving pattern; and

an actual measurement extraction portion that extracts, from the actual measurement data in the predetermined period, the actual measurements at each point or in each section in the equivalent driving pattern.

While the embodiment according to the present invention is described above, this is not meant as any limitation on the scope of the present invention, and thus this can be implemented with various extensions and modifications without departing from the spirit of the present invention.

**Industrial Applicability**

The present invention can be applied to vehicle diagnosis devices that conduct diagnosis on vehicles based on the condition of consumption of the driving energy of the vehicle.

**Reference Signs List**

| | |
|---|---|
| 1 | vehicle diagnosis device |
| 3 | data acquisition portion (characteristic data acquisition portion, actual data acquisition portion, reference consumption acquisition portion) |
| 21 | characteristic data storage portion (characteristic data acquisition portion) |
| 22 | reference consumption storage portion (reference consumption acquisition portion) |
| 62 | equivalent pattern generator |
| 63 | total consumption calculator |
| 6P | actual measurement extraction portion |
| 64 | judging portion |
| 65 | estimation portion |
| 66 | resistance change calculator (change calculator) |
| 67 | voltage change calculator (change calculator) |
| 70 | change calculator |
| 100 | vehicle |
| 103 | HV battery (battery) |
| 111 | data recording device |
| P1 to Pn | profile (characteristic data) |

## EP 4 644 932 A1

**Claims**

1.  A vehicle diagnosis device that conducts diagnosis on a vehicle comprising:

    a characteristic data acquisition portion that acquires a plurality of sets of characteristic data included in a predetermined output pattern of the vehicle;
    an actual data acquisition portion that acquires output data based on actual driving of the vehicle in a predetermined period in a past and actual measurement data obtained during driving of the vehicle in the predetermined period as representing actual measurements as to a parameter required in vehicle diagnosis;
    an equivalent pattern generator that cuts out points or sections that are similar to a plurality of sets of the characteristic data from the output data in the predetermined period to generate an equivalent output pattern that is regarded as equivalent to the predetermined output pattern; and
    an actual measurement extraction portion that extracts, from the actual measurement data in the predetermined period, the actual measurements at each point or in each section in the equivalent output pattern.

2.  The vehicle diagnosis device according to claim 1, wherein

    the actual measurement data includes actual consumption data representing as the actual measurements energy consumption during driving of the vehicle in the predetermined period, and
    the actual measurement extraction portion includes a total consumption calculator extracting and adding up, from the actual consumption data in the predetermined period, the energy consumption at each point or in each section in the equivalent output pattern to calculate total energy consumption.

3.  The vehicle diagnosis device according to claim 2, further comprising:

    a reference consumption acquisition portion that acquires data about energy consumption of the vehicle per predetermined output pattern as data of reference energy consumption; and
    a judging portion that makes a judgment on condition of the vehicle based on the reference energy consumption and the total energy consumption.

4.  The vehicle diagnosis device according to claim 3, wherein

    the actual data acquisition portion acquires, from the vehicle, data representing power consumption of the vehicle during driving in the predetermined period as the actual consumption data,
    the total consumption calculator calculates the total energy consumption by adding up, based on the actual consumption data, the power consumption at each point or in each section in the equivalent output pattern, and
    based on the reference energy consumption and the total energy consumption, the judging portion judges, as the condition of the vehicle, a degree of deterioration of a battery that stores power.

5.  The vehicle diagnosis device according to claim 4, wherein
    the reference energy consumption is an amount consumed from the power stored in the battery during driving of the vehicle in a predetermined driving pattern as the predetermined output pattern.

6.  The vehicle diagnosis device according to claim 4 or 5 further comprising
    an estimation portion that estimates, based on the degree of deterioration of the battery judged by the judging portion, the degree of deterioration of the battery or power consumption per predetermined driving pattern as the predetermined output pattern at a lapse of a predetermined period after completion of manufacture of the vehicle.

7.  The vehicle diagnosis device according to any one of claims 4 to 6, wherein

    the actual data acquisition portion further acquires, from the vehicle, data about usage condition and environment of the vehicle, and
    the total consumption calculator excludes the power consumption from the battery occurring due to the usage condition and the environment of the vehicle in calculating the total energy consumption from the battery.

8.  The vehicle diagnosis device according to claim 1, wherein

    the actual measurement data includes actual battery data representing as the actual measurements at least one of a current value and a voltage value of the battery during driving of the vehicle in the predetermined period, the actual measurement extraction portion includes a change calculator that extracts, from the actual battery data in the predetermined period, at least one of the current value and the voltage value of the battery at each point or in each section in the equivalent output pattern and calculates, based on the value extracted, a change from a reference of an internal resistance of the battery, a change from a reference of the voltage value extracted, or a change from a reference of the current value extracted, and

the vehicle diagnosis device further includes a judging portion that judges condition of the vehicle based on the change calculated by the change calculator.

9. The vehicle diagnosis device according to claim 8, wherein
the judging portion judges, if a temperature of the battery lies in a predetermined temperature range, the condition of the vehicle and judges, if the temperature of the battery is out of the predetermined temperature range, the condition of the vehicle with the voltage value of the battery corrected to a voltage value at a predetermined temperature.

10. The vehicle diagnosis device according to claim 1, wherein

the actual measurement data includes actual emission data representing as actual measurements an emission amount of a predetermined component contained in exhaust gas during driving of the vehicle in the predetermined period,

the actual measurement extraction portion includes a total emission calculator that adds up, based on the actual emission data, the emission amount at each point or in each section in the equivalent output pattern to calculate a total emission amount, and

the vehicle diagnosis device further includes a judging portion that judges condition of the vehicle based on the total emission amount calculated by the total emission calculator.

11. The vehicle diagnosis device according to claim 3, wherein

the actual data acquisition portion acquires, from the vehicle, as the actual consumption data, data representing fuel consumption of the vehicle during driving in the predetermined period,

based on the actual consumption data, the total consumption calculator adds up the fuel consumption accompanying each point in the equivalent output pattern to calculate the total energy consumption, and

based on the reference energy consumption and the total energy consumption, the judging portion judges, as the condition of the vehicle, a degree of deterioration of an internal combustion engine.

12. The vehicle diagnosis device according to claim 3, wherein

the actual data acquisition portion acquires, from the vehicle, as the actual consumption data, data representing an emission amount of a predetermined component contained in exhaust gas of the vehicle during driving in the predetermined period,

based on the actual consumption data, the total consumption calculator adds up the emission amount accompanying each point in the equivalent output pattern to calculate the total energy consumption, and

based on the reference energy consumption and the total energy consumption, the judging portion judges, as the condition of the vehicle, a degree of deterioration of an internal combustion engine.

13. The vehicle diagnosis device according to claim 11 or 12, wherein

the predetermined output pattern is a set of points indicating a relationship between revolutions per minute and torque of an engine as the internal combustion engine, and

the equivalent output pattern is a set of points that are regarded as equivalent to points in the predetermined output pattern.

14. A vehicle diagnosis method comprising:

an equivalent pattern generation step of cutting out, from output data based on actual driving of a vehicle in a predetermined period in a past, points or sections that are similar to a plurality of sets of characteristic data included in a predetermined output pattern of the vehicle to generate an equivalent output pattern that is regarded as equivalent to the predetermined output pattern; and

an actual measurement extraction step of extracting, from actual measurement data obtained during driving of the vehicle in the predetermined period as representing actual measurements as to a parameter required in vehicle diagnosis, the actual measurements at each point or in each section in the equivalent output pattern.

15. A vehicle diagnosis program for making a computer carry out the vehicle diagnosis method according to claim 14.

16. The vehicle diagnosis device according to any one of claims 1 to 13, wherein

the predetermined output pattern of the vehicle is a predetermined driving pattern of the vehicle,
the output data based on the actual driving is actual driving data of the vehicle in a predetermined period in a past, and
the equivalent output pattern is a pattern that is regarded as equivalent to the predetermined driving pattern.

# FIG.1

CONTROLLER

| MAIN CONTROLLER | — 61 |

| EQUIVALENT PATTERN GENERATOR | — 62 |

ACTUAL MEASUREMENT EXTRACTION PORTION

| TOTAL CONSUMPTION CALCULATOR | — 63 |

— 6P

| JUDGING PORTION | — 64 |

| ESTIMATION PORTION | — 65 |

— 6

STORAGE

| CHARACTERISTIC DATA STORAGE PORTION | — 21 |

| REFERENCE CONSUMPTION STORAGE PORTION | — 22 |

| PROGRAM STORAGE PORTION | — 23 |

— 2

| DATA ACQUISITION PORTION | — 3 |

| DISPLAY | — 4 |

| INPUT PORTION | — 5 |

1

**FIG.2**

WLTC DRIVING PATTERN (AT CERTIFICATION)

# FIG.3

WLTC DRIVING PATTERN

EP 4 644 932 A1

FIG.4

100

101 ELECTRIC MOTOR
102 INVERTER
103 HV BATTERY
104 ON-BOARD CHARGE UNIT
105 PTC HEATER
106 A/C COMPRESSOR
107 DC-DC CONVERTER
108 LV BATTERY
116 GPS
100N
109 POWER CONTROL ECU
110 BATTERY MANAGEMENT ECU
111 DATA RECORDING DEVICE
112 HVAC ECU
113 INDICATOR
114 BRAKE ECU
115 VEHICLE SPEED SENSOR

═══ ELECTRIC POWER SUPPLY PATH
——— SIGNAL TRANSMISSION PATH

# FIG.5

PASSAGE OF TIME

| FIRST TEST | SECOND TEST | THIRD TEST |

SAVE ACTUAL DRIVING DATA IN PREDETERMINED PERIOD | OUTPUT ACTUAL DRIVING DATA

SAVE ACTUAL DRIVING DATA IN PREDETERMINED PERIOD | OUTPUT ACTUAL DRIVING DATA

SAVE ACTUAL DRIVING DATA IN PREDETERMINED PERIOD | OUTPUT ACTUAL DRIVING DATA

MEASUREMENT/ESTIMATION APPLICATION

MEASUREMENT/ESTIMATION APPLICATION

MEASUREMENT/ESTIMATION APPLICATION

COMPARE/ DIAGNOSE

COMPARE/ DIAGNOSE

COMPARE/ DIAGNOSE

1

EP 4 644 932 A1

FIG.6

START

ACQUIRE ACTUAL DATA (ACTUAL DRIVING DATA, ACTUAL CONSUMPTION DATA) — S1

GENERATE EQUIVALENT DRIVING PATTERN — S2

CALCULATE TOTAL ENERGY CONSUMPTION — S3

JUDGE VEHICLE CONDITION (E.G., DEGREE OF BATTERY DETERIORATION) — S4

ESTIMATE DEGREE OF DETERIORATION OR CONSUMPTION AT PREDETERMINED PERIOD AFTER COMPLETION OF MANUFACTURE OF VEHICLE — S5

END

# FIG.7

ACTUAL DRIVING DATA IN PREDETERMINED PERIOD

EQUIVALENT DRIVING PATTERN

EP 4 644 932 A1

FIG.8

Acel/Decel [m/s^2]

[km/h]

[m/s^2]

FIG.9

m/s$\hat{}$2

km/h

○ WLTC

▨ ACTUAL MEASUREMENT VALUE

m/s$\hat{}$2

km/h

○ WLTC

▨ ACTUAL MEASUREMENT VALUE

FIG.10

INITIAL STAGE (BEFORE BATTERY DETERIORATION)

AT TEST (AFTER BATTERY DETERIORATION)

$$\frac{dSOC}{dw} = \frac{\Delta SOC(Initial)}{W2}$$

SOC1 100%

$\Delta SOC(Initial)$

SOC2

W2    $W_{int}$

$$\frac{dSOC}{dw} = \frac{\sum_{k=1}^{n} \Delta SOC_k}{\sum_{k=1}^{n} W_{sk}}$$

SOC1 100%

$\sum_{k=1}^{n} \Delta SOC_k$

SOC2

$\sum_{k=1}^{n} W_{sk}$    $W_{age}$

$$\text{DETERIORATION RATE} = \frac{W_{age}}{W_{int}} \, [\%]$$

$$\text{NUMBER OF CYCLES} \begin{cases} \text{INITIAL STAGE} : 100/\Delta SOC(Initial) \\ \text{AFTER DETERIORATION} : 100/\sum_{k=1}^{n} \Delta SOC_k \end{cases}$$

EP 4 644 932 A1

FIG.11

ACTUAL DRIVING DATA AT INITIAL STAGE (BEFORE BATTERY DETERIORATION)

SPEED (km/h)

80 70 60 50 40 30 20 10 0

TIME (sec)

5400

Profile Table

P1 P2 ... Pm ... Pn

EXTRACT, FROM ACTUAL DRIVING DATA, DATA OF SECTION THAT MATCHES PROFILE

SPEED (km/h)

TIME (sec)

EQUIVALENT DRIVING PATTERN

SPEED (km/h)

TIME (sec)

## FIG.12

SPEED (km/h)

ACTUAL DRIVING DATA IN PREDETERMINED PERIOD

TIME (sec)

P1

$V_1$
$dv$
$V_0$
$dt$
$V_0 \leqq V \leqq V_1$
$a\_table = dv/dt$

R1

$V_1$
$dv$
$V_0$
$dt$
$V_0 \leqq V \leqq V_1$
$a\_real = dv/dt$

$a\_table \doteqdot a\_real$

PROBABILITY (Probability P[%])

$$P_n = (a\_table / a\_real) \times dt / t\_total$$

| | Profile Table | Real Profile | $P_n$ |
|---|---|---|---|
| 1 | | | $|P_1|$ |
| 2 | | | $|P_2|$ |
| . | . | . | |
| n | | | $|P_n|$ |

DEGREE OF MATCHING (PROBABILITY) $\sum_{k=1}^{n} |P_k|$

## FIG.13

$$SOC_{CO} = \sum_{k=1}^{n} \Delta SOC'_k$$

SOC1 100%

$$\frac{dSOC}{dw} = \frac{\sum_{k=1}^{n} \Delta SOC_k}{\sum_{k=1}^{n} W_{sk}}$$

$$\sum_{k=1}^{n} \Delta SOC_k$$

$$\sum_{k=1}^{n} W_{sk}$$

$$W_{age}$$

$$Wc = \sum_{k=1}^{n} W_{sk} - (\Delta W_{LV} + W_{RL})$$

NUMBER OF CYCLES    AFTER DETERIORATION : $100 / \sum_{k=1}^{n} \Delta SOC'_k$

FIG.14

CONTROLLER

| MAIN CONTROLLER | — 61 |

| EQUIVALENT PATTERN GENERATOR | — 62 |

ACTUAL MEASUREMENT EXTRACTION PORTION

| TOTAL CONSUMPTION CALCULATOR | — 63 |

| RESISTANCE CHANGE CALCULATOR | — 66 |
| VOLTAGE CHANGE CALCULATOR | — 67 |

— 70

| TOTAL INJECTION CALCULATOR | — 68 |

| TOTAL EMISSION CALCULATOR | — 69 |

6P

| JUDGING PORTION | — 64 |

| ESTIMATION PORTION | — 65 |

6

1

FIG.15

FIG.16

FIG.17

FIG.18

FIG.19

FIG.20

## FIG.21

## FIG.22

L=11.9m/sX1X1/10s

FIG.23A

FIG.23B

FIG.24A

FIG.24B

FIG.25

FIG.26

FIG.27

FIG.28

FIG.29A

FIG.29B

FIG.30A

FIG.30B

FIG.31

FIG.32

## INTERNATIONAL SEARCH REPORT

| International application No. |
| --- |
| **PCT/JP2023/037166** |

**A. CLASSIFICATION OF SUBJECT MATTER**

*G01R 31/392*(2019.01)i; *B60L 3/00*(2019.01)i; *B60L 15/20*(2006.01)i; *B60L 50/60*(2019.01)i; *B60L 58/12*(2019.01)i; *B60L 58/16*(2019.01)i; *F02D 45/00*(2006.01)i; *G01M 17/007*(2006.01)i; *G01R 31/367*(2019.01)i; *G01R 31/382*(2019.01)i; *G01R 31/385*(2019.01)i; *G01R 31/389*(2019.01)i; *H01M 10/42*(2006.01)i; *H01M 10/48*(2006.01)i

FI: G01R31/392; B60L3/00 N; B60L3/00 S; B60L15/20 J; B60L50/60; B60L58/12; B60L58/16; F02D45/00 345; G01M17/007 H; G01R31/367; G01R31/382; G01R31/385; G01R31/389; H01M10/42 P; H01M10/48 P; H01M10/48 301

According to International Patent Classification (IPC) or to both national classification and IPC

**B. FIELDS SEARCHED**

Minimum documentation searched (classification system followed by classification symbols)

G01R31/392; B60L3/00; B60L15/20; B60L50/60; B60L58/12; B60L58/16; F02D45/00; G01M17/007; G01R31/367; G01R31/382; G01R31/385; G01R31/389; H01M10/42; H01M10/48

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2010-1005 A (MIKI, Nobuaki) 07 January 2010 (2010-01-07) paragraphs [0001]-[0092], fig. 1-20 | 1-3, 14-16 |
| Y | | 4-13 |
| Y | JP 2007-74891 A (TOYOTA JIDOSHA KABUSHIKI KAISHA) 22 March 2007 (2007-03-22) paragraphs [0001]-[0065], fig. 1-9 | 4-9 |
| Y | JP 2017-522212 A (AVL LIST GMBH) 10 August 2017 (2017-08-10) paragraphs [0001]-[0175], fig. 1-18 | 10-13 |
| A | CN 112197827 A (ANHUI JIANGHUAI AUTOMOBILE GROUP CORP., LTD.) 08 January 2021 (2021-01-08) entire text, all drawings | 1-16 |

✓ Further documents are listed in the continuation of Box C.  ✓ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
| --- | --- |
| **01 December 2023** | **19 December 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT

| International application No. |
| :--- |
| **PCT/JP2023/037166** |

**C.      DOCUMENTS CONSIDERED TO BE RELEVANT**

| Category* | Citation of document, with indication, where appropriate, of the relevant passages | Relevant to claim No. |
| :---: | :--- | :---: |
| A | CN 112758078 A (GEELY AUTOMOBILE RESEARCH INSTITUTE (NINGBO) CO., LTD.) 07 May 2021 (2021-05-07)<br>entire text, all drawings | 1-16 |

Form PCT/ISA/210 (second sheet) (January 2015)

**INTERNATIONAL SEARCH REPORT**
Information on patent family members

International application No.

**PCT/JP2023/037166**

| Patent document cited in search report | | | Publication date (day/month/year) | Patent family member(s) | Publication date (day/month/year) |
|---|---|---|---|---|---|
| JP | 2010-1005 | A | 07 January 2010 | (Family: none) | |
| JP | 2007-74891 | A | 22 March 2007 | US 2007/0029974 A1 paragraphs [0001]-[0073], fig. 1-9 DE 102006000397 A1 CN 1913217 A | |
| JP | 2017-522212 | A | 10 August 2017 | US 2017/0268948 A1 paragraphs [0001]-[0263], fig. 1-18 WO 2015/166067 A1 DE 102014006322 A1 KR 10-2016-0145826 A CN 106662501 A | |
| CN | 112197827 | A | 08 January 2021 | (Family: none) | |
| CN | 112758078 | A | 07 May 2021 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007195312 A